# EUROPÄISCHE PATENTSCHRIFT

(11) **EP 3 969 821 B1**
(45) Veröffentlichungstag und Bekanntmachung des Hinweises auf die Patenterteilung: **14.10.2026**
(21) Anmeldenummer: 20727211.3
(22) Anmeldetag: 15.05.2020
(51) Int. Cl.: F24S 25/40, F24S 10/50, F24S 20/69, F24S 80/30, H02S 20/25, H02S 40/44

(54) **SOLARENERGIEDACHPFANNE, SOLARENERGIESYSTEM, SOWIE VERFAHREN ZUR GEWINNUNG VON ENERGIE AUS SONNENSTRAHLUNG**
SOLAR ENERGY ROOF PAN, SOLAR ENERGY SYSTEM, AND PROCESS FOR GENERATING ENERGY FROM SUN RADIATION
PANNEAU DE TOIT À ÉNERGIE SOLAIRE, SYSTÈME D'ÉNERGIE SOLAIRE ET PROCÉDÉ DE PRODUCTION D'ÉNERGIE À PARTIR DES RAYONNEMENTS SOLAIRES

(30) Priorität: 15.05.2019 DE 102019112799
(43) Veröffentlichungstag der Anmeldung: 23.03.2022
(73) Patentinhaber: Swift Solar Inc., San Carlos, CA 94070 (US)
(72) Erfinder: HAKENBERG, Peter, 42719 Solingen (DE)
(74) Vertreter: Krujatz, Jörg Martin
(86) Internationale Anmeldenummer: PCT/EP2020/063711
(87) Internationale Veröffentlichungsnummer: WO 2020/229686

(56) Entgegenhaltungen:
- EP-A1- 0 018 543
- EP-A1- 0 018 543
- WO-A1-02/101839
- WO-A1-02/101839
- WO-A2-00/77860
- WO-A2-00/77860
- WO-A2-2008/137966
- WO-A2-2008/137966
- WO-A2-2008/137966
- DE-A1- 102016 107 016
- DE-A1- 102016 107 016
- DE-A1- 102016 107 016
- DE-A1- 2 529 095
- DE-A1- 2 529 095
- DE-A1- 2 529 095
- FR-A1- 2 931 855
- FR-A1- 2 931 855
- US-A- 5 480 494
- US-A- 5 480 494
- US-A1- 2014 158 648
- US-A1- 2014 158 648
- US-A1- 2018 224 159
- US-A1- 2018 224 159
- US-B2- 6 521 821
- US-B2- 6 521 821

## Beschreibung

Die vorliegende Erfindung betrifft eine Solarenergiedachpfanne, wobei die Solarenergiedachpfanne im Wesentlichen die Form einer herkömmlichen Dachpfanne aufweist. Ferner betrifft die vorliegende Erfindung ein Solarenergiesystem, sowie ein Verfahren zur Gewinnung von Energie aus Sonnenstrahlung und gleichzeitiger Nutzung der Abwärme.

Unter einer Solarenergiedachpfanne kann zum einen eine Photovoltaikdachpfanne, zum anderen eine Solarthermiedachpfanne, sowie des Weiteren eine kombinierte Dachpfanne (auch Kombinationsdachpfanne genannt), welche beide Techniken in Form von Photovoltaik und auch Solarthermie nutzt, verstanden werden. Eine Photovoltaikdachpfanne ist zur Gewinnung elektrischer Energie aus Sonnenenergie eingerichtet und weist hierzu auf ihrer bestimmungsgemäß im Betrieb regelmäßig der Sonne zugewandten Oberseite ein Photovoltaikmodul auf. Eine Solarthermiedachpfanne wiederum ist zur Gewinnung thermischer Energie aus Sonnenstrahlung eingerichtet und weist hierzu auf ihrer bestimmungsgemäß im Betrieb regelmäßig der Sonne zugewandten Oberseite ein Solarthermiemodul auf. Als obergeordneter Begriff für die beiden spezifischen Beispiele Photovoltaikmodul und Solarthermiemodul wird im Rahmen der vorliegenden Anmeldung der Begriff Solarenergienutzungsmodul benutzt. Bei einer Solarenergiedachpfanne, die als kombinierte Dachpfanne zur Nutzung beider Technologien ausgebildet ist, ist auf der bestimmungsgemäß im Betrieb regelmäßig der Sonne zugewandten Oberseite ein solches Solarenergienutzungsmodul vorgesehen, welches sowohl ein Photovoltaikmodul als auch ein Solarthermiemodul umfasst. Es werden sodann sowohl elektrische Energie als auch thermische Energie aus der Sonnenstrahlung mittels des Solarenergienutzungsmoduls gewonnen bzw. genutzt.

Solarthermie, insbesondere die Bereitstellung von Warmwasser ist eine weite verbreitete Technik zur Nutzung der Sonnenstrahlung. Dabei werden Solarkollektoren zur Erwärmung von Flüssigkeit verwendet. Die Sonnenstrahlung trifft dabei auf eine Absorberfläche des Kollektors und erwärmt diese. Die gewonnene Wärme wird auf ein durchströmendes Medium, üblicherweise eine Flüssigkeit oder auch Luft, übertragen. Das von der Sonneneinstrahlung erwärmte Medium wird in der Regel mit einer Umwälzpumpe zu einem Warmwasserspeicher geleitet, wobei die gewonnene Wärme über einen Wärmetauscher von dem erwärmten Medium (z.B. einer Trägerflüssigkeit), an das Nutz- oder Trinkwasser im Warmwasserspeicher übertragen. Das Medium kühlt sich dabei ab und wird anschließend zurück zum Kollektor, sprich dem Sammler für das Medium, zurück geführt.

Wird eine Flüssigkeit als Medium verwendet, eignet sich insbesondere ein Frostschutz-Wasser-Gemisch. Alternativ kann Heizungswasser selbst in den Kollektor gepumpt und darin erwärmt werden. Auch in diesem Fall kann Trinkwasser über den Wärmetauscher erwärmt werden.

Solarthermiedachpfannen und die Nutzung von Dachflächen für die Anbringung von Solarthermiedachpfannen sind bekannt. Solarthermiedachpfannen können anstelle der üblicherweise verwendeten Dachpfannen, Dachziegel oder Dachsteine verwendet werden. Solarthermiedachpfannen beinhalten ebenfalls einen Absorber zur Aufnahme der Sonnenenergie und werden durch ein Medium, vorzugsweise eine Flüssigkeit durchströmt, das sich entsprechend erwärmt. Die Installation derartiger Solardachpfannen ist aufwendig und im Verhältnis zur herkömmlichen Dacheindeckung mit handelsüblichen Dachziegeln relativ schwierig. Ein wesentliches Problem besteht dabei insbesondere in dem hohen Montageaufwand für die Verbindung der einzelnen Solarthermiedachpfannen. Das durchströmende Medium muss von einer Solarthermiedachpfanne zur nächsten geleitet werden, die Verbindung muss entsprechend dicht ausgeführt sein. Der Montage- und Zeitaufwand ist somit vor allem bedingt durch das Herstellen der Verbindungen der Fluidleitungen deutlich höher. Im Rahmen dieser Anmeldung wird ein solches Herstellen der Verbindung benachbarter Solarthermiedachpfannen bzw. allgemein der Verbindung von Fluidleitungen bzw. fluidführenden Leitungen benachbarter Solarenergiedachpfannen auch als das Herstellen einer thermisch leitenden Verbindung zwischen benachbarten Solarthermiedachpfannen bezeichnet.

Wenn im Rahmen der vorliegenden Anmeldung von benachbarten Solarenergiedachpfannen gesprochen wird, so sind regelmäßig die in einem auf dem Dach montierten Zustand in vertikaler Richtung benachbarte Dachpfannen gemeint, sprich nach oben Richtung Dachfirst bzw. nach unten Richtung Dachrinne benachbarte Dachpfannen, und nicht etwa nach links bzw. rechts, in einer horizontalen Richtung benachbarte Dachpfannen. Insofern doch Bezug zu in horizontaler Richtung (nach links oder rechts) benachbarten Dachpfannen gemacht werden soll, wird darauf hingewiesen.

Beschrieben ist eine zuvor erwähnte Solarthermiedachpfanne und ihre Montage beispielsweise in der DE 10 2011 055 904 A1 und in der DE 20 2013 002 407 U1. Die Installation der darin beschriebenen Dachziegel ist aufwendig und schwierig, insbesondere weil zusätzlich Bauteile benötigt werden und Änderungen an der Tragekonstruktion notwendig sind.

Hier soll die vorliegende Erfindung Abhilfe schaffen. Nachfolgend ist die vorliegende Erfindung jedoch insbesondere am Beispiel der Technik Photovoltaik beschrieben, und zwar konkret am Beispiel einer Photovoltaikdachpfanne. Die später beschriebenen Vorteile sind jedoch ebenso auf eine Solarthermiedachpfanne bzw. eine kombinierte Dachpfanne (Kombinationsdachpfanne), die beide Techniken in Form von Solarthermie sowie Photovoltaik nutzt, übertragbar.

Photovoltaik ist ebenfalls eine bereits weit verbreitete Technik zur Nutzung der Sonnenstrahlung. Die Sonnenstrahlung trifft dabei auf ein Photovoltaikmodul mit Solarzellen. Diese wandeln die Energie des Sonnenlichts in elektrisch nutzbare Energie um. Die Umwandlung von Sonnenenergie in elektrisch nutzbare Energie ist hinlänglich bekannt und wird nicht näher erläutert.

Die Nutzung von Dachflächen für die Anbringung von Solarkollektoren ist weit verbreitet. Handelsübliche Solarkollektoren werden dabei meist auf bereits fertiggestellte Dächer zusätzlich aufgebracht. Insofern spricht man auch von aufgeständerten Sonnenkollektoren. Dabei müssen oftmals Befestigungselemente durch die Dachhaut auf die Dachtragekonstruktion montiert werden, wobei die Befestigung sturmfest und vorzugsweise auch korrosionsgeschützt sein muss. Beim Durchstoßen der konventionellen Dachhaut werden zwangsläufig Abdichtungs- und anschließende Dichtigkeitsprobleme hervorgerufen. Hinzu kommt eine Erhöhung der Dachlast, was oftmals eine notwendige Verstärkung im Dachstuhl nach sich zieht. Hinzu kommt, dass derartige Sonnenkollektoren das optische Erscheinungsbild des Daches negativ beeinträchtigen.

Alternativ sind Photovoltaikdachpfannen bekannt, die anstelle der üblicherweise verwendeten Dachpfannen, Dachziegel oder Dachsteine verwendet werden. Photovoltaikdachpfannen beinhalten oberseitig, also der Sonne zugewandt, Photovoltaikmodule bzw. Solarzellen zur Aufnahme und Umwandlung der Sonnenenergie. Die oben genannten Nachteile der aufgeständerten, also auf ein bereits eingedecktes Dach zusätzlich aufgebrachten Sonnenkollektoren werden dadurch weitgehend vermieden, allerdings ist die Installation von Photovoltaikdachpfannen aufwendig und im Verhältnis zur herkömmlichen Dacheindeckung mit handelsüblichen Dachziegeln relativ schwierig. Ein wesentliches Problem besteht dabei insbesondere in dem hohen Montageaufwand für die elektrische Verbindung der einzelnen Photovoltaikdachpfannen. Der elektrische Strom muss von einer Photovoltaikdachpfanne zur nächsten geleitet werden, weswegen der Montage- und Zeitaufwand aufgrund der Verbindungsarbeiten deutlich höher als bei großflächigen Solarkollektoren ist.

Beschrieben ist eine solche Photovoltaikdachpfanne und ihre Montage beispielsweise in der DE 10 2011 055 904 A1 und in der DE 20 2013 002 407 U1. Die Installation der darin beschriebenen Dachziegel ist aufwendig und schwierig, insbesondere weil zusätzlich Bauteile benötigt werden und Änderungen an der Tragekonstruktion notwendig sind. Hier bietet bereits eine Photovoltaikdachpfanne Abhilfe, wie sie beispielsweise in der DE 10 2016 104 096 A1 offenbart ist, wobei auch dort die Montage weiter optimiert werden kann.

Alle vorgenannten Solarenergiedachpfannen sind ferner weiterhin hinsichtlich einer effizienten Energienutzung optimierungsbedürftig. Denn im Rahmen einer geforderten immer weiter verbesserten Energienutzung von Haushalten ist es erstrebenswert, die durch die Sonnenstrahlung zur Verfügung gestellte Energie bestmöglich und auf einfache Weise zu nutzen.

WO 2008/137966 A2 offenbart einer Solarenergiedachpfanne gemäß dem Oberbegriff des Anspruchs 1.

Die Aufgabe der vorliegenden Erfindung besteht somit darin, eine Solarenergiedachpfanne bereitzustellen, deren Herstellung, Montage und Wartung möglichst einfach und kostengünstig ist. Weiterhin ist es wünschenswert, dass die Energieausbeute weiter optimiert ist. Dabei sollte sich der Montagevorgang möglichst wenig von einer Dacheindeckung mit üblichen Dachziegeln unterscheiden.

Die Aufgabe wird durch eine Solarenergiedachpfanne mit den Merkmalen des Patentanspruchs 1 gelöst. Ferner wird die Aufgabe durch ein erfindungsgemäßes Solarenergiesystem gemäß der vorliegenden Offenbarung sowie durch ein erfindungsgemäßes Verfahren gemäß der vorliegenden Offenbarung gelöst.

Wesentlich für die Erfindung ist die Erkenntnis, dass jeweils zwei Öffnungen, nämlich eine obere Öffnung in der Oberseite der Solarenergiedachpfanne sowie eine untere Öffnung in der Unterseite der Solarenergiedachpfanne, bereitgestellt werden, über welche beiden Öffnungen Montagearbeiten einfach durchgeführt werden können. Dabei können erforderliche Verbindungen beispielsweise von der Solarenergiedachpfanne zu darunter liegenden Dachlatten, aber auch von benachbarten Solarenergiedachpfannen untereinander, hergestellt, aber bei Bedarf auch wieder gelöst, werden. Dabei ist besonders vorteilhaft, dass solche Montagearbeiten immer von oben, von der Oberseite einer Solarenergiedachpfanne aus, durchgeführt werden können. So kann durch die obere Öffnung ein Zugriff in eine Solarenergiedachpfanne, und somit auch bis hin zu der Unterseite der Dachpfanne, von oben erfolgen. Bei in vertikaler Richtung benachbart angeordneten Solarenergiedachpfannen, beispielsweise in einem Solarenergiesystem, kann sodann durch die untere Öffnung in der Unterseite der Zugriff beispielsweise auch in die nächste, weiter unterhalb angeordnete Solarenergiedachpfanne, und zwar insbesondere erneut von oben, gewährleistet sein. So können die obere Öffnung einer unterhalb angeordneten Solarenergiedachpfanne und die untere Öffnung einer oberhalb benachbarten Solarenergiedachpfanne wenigstens teilweise in Übereinstimmung gebracht sein. Sodann kann von oben über die obere Öffnung ein Zugriff in den Hohlraum der oberhalb angeordneten Solarenergiedachpfanne erfolgen. Sodann kann weiterhin auch der Zugriff durch die in Übereinstimmung gebrachte untere Öffnung dieser Solarenergiedachpfanne und weiter durch die obere Öffnung der darunter liegenden Solarenergiedachpfanne auch in den Hohlraum der darunter benachbarten Solarenergiedachpfanne erfolgen. Auf diese Weise können besonders einfach die erforderlichen elektrischen und auch thermischen leitenden Verbindungen zwischen benachbarten Solarenergiedachpfannen in einem Solarenergiesystem realisiert werden.

Im Einzelnen wird eine Solarenergiedachpfanne vorgeschlagen, deren Form im Wesentlichen der Form einer herkömmlichen Dachpfanne entspricht und die mit einer benachbarten Solarenergiedachpfanne thermisch und/oder elektrisch leitend verbindbar ist. Die Solarenergiedachpfanne weist dabei auf:
- eine Unterseite zur zumindest bereichsweisen Auflage auf einer Dachkonstruktion,
- eine der Unterseite gegenüberliegende Oberseite, die zumindest bereichsweise durch ein Solarenergienutzungsmodul gebildet ist,
- zwei gegenüberliegende Seitenwände,
- eine die zwei Seitenwände verbindende Rückseite, und
- eine der Rückseite gegenüberliegende und ebenfalls die zwei Seitenwände verbindende Frontseite.

Die zwei Seitenwände, die Rückseite sowie die Frontseite verbinden dabei gemeinsam die Unterseite und die Oberseite, sodass ein Hohlraum zwischen den zwei Seitenwänden, der Rückseite, der Frontseite, der Unterseite und der Oberseite ausgebildet ist. Die Unterseite weist im Bereich der Frontseite eine untere Öffnung zum Bereitstellen eines Zugriffs und die Oberseite im Bereich der Rückseite obere Öffnung zum Bereitstellen eines Zugriffs aus der Umgebung in den Hohlraum auf.

Nach einer Ausführungsvariante kann die Solarenergiedachpfanne als Photovoltaikdachpfanne zur Gewinnung elektrischer Energie aus Sonnenstrahlung ausgebildet sein und das Solarenergienutzungsmodul als Photovoltaikmodul ausgebildet sein. Alternativ kann die Solarenergiedachpfanne auch als Solarthermiedachpfanne zur Gewinnung thermischer Energie aus Sonnenstrahlung ausgebildet sein und das Solarenergienutzungsmodul als Solarthermiemodul ausgebildet sein. Es kann jedoch auch die Solarenergiedachpfanne als kombinierte Dachpfanne (Kombinationsdachpfanne) zur Gewinnung elektrischer und thermischer Energie aus Sonnenstrahlung ausgebildet sein und das Solarenergienutzungsmodul sowohl als Photovoltaikmodul als auch als Solarthermiemodul ausgebildet sein. Das Solarthermiemodul dient wie eingangs beschrieben dazu, die durch die Sonnenstrahlung aufgenommene Wärme an ein Fluid abzugeben und auf diese Weise die thermische Energie zu nutzen.

Wenn im Rahmen dieser Anmeldung von einer Solarenergiedachpfanne gesprochen wird, so kann darunter also sowohl eine Photovoltaikdachpfanne als auch eine Solarthermiedachpfanne als auch eine kombinierte Dachpfanne verstanden werden. Die Vorteile der vorliegenden Erfindung werden nachfolgend insbesondere am Beispiel der Photovoltaikdachpfanne erläutert. Diese Vorteile sind jedoch auch regelmäßig auf die anderen beiden genannten Solarenergiedachpfannentypen übertragbar. Insbesondere sind die auf die Herstellung von elektrischen Verbindungen bezogenen Vorteile auch auf die Herstellung von thermischen Verbindungen, insbesondere dem Herstellen der Verbindung zwischen Fluidleitungen bzw. fluidführenden Leitungen, zwischen benachbarten Solarthermiedachpfannen übertragbar.

Gemäß einer vorteilhaften Ausbildung der Solarenergiedachpfanne ist vorgesehen, dass die untere Öffnung als eine Einströmöffnung für aus der Umgebung anströmende Umgebungsluft in den Hohlraum und die obere Öffnung als eine Ausströmöffnung für die Umgebungsluft aus dem Hohlraum ausgebildet ist. Dadurch wird die Energieausbete in besondere Weise optimiert. Dies wird am Beispiel einer Photovoltaikdachpfanne klar. So kann innerhalb der vorschlagsgemäßen Photovoltaikdachpfanne ein Raum zur Verfügung gestellt werden, in welchem die Abwärme, etwa des sich erhitzenden Photovoltaikmoduls, genutzt werden kann. Dabei kann die entstehende Wärme auf einfache Weise an die Photovoltaikdachpfanne durchströmende Umgebungsluft abgegeben werden, die später gezielt eingesetzt und genutzt werden kann, zum Beispiel im Haushalt mittels einer Wärmepumpe, die durch die erwärmte Luft betrieben werden kann. Dazu weist die Photovoltaikdachpfanne eine Einströmöffnung für anströmende Umgebungsluft auf und ferner eine Ausströmöffnung für die dann erwärmte Umgebungsluft. Auf ihrem Weg durch das Innere der Photovoltaikdachpfanne strömt die Umgebungsluft unter anderem an dem Photovoltaikmodul bzw. an dem Photovoltaikmodul angrenzenden Bauteilen vorbei und nimmt die dort entstehende Wärme auf. In einem auf einer Dachkonstruktion montierten Zustand mit mehreren (in vertikaler Richtung gesehen oberhalb und unterhalb) benachbarten Photovoltaikdachpfannen ist die Einströmöffnung bezogen auf die im Wesentlichen horizontale Lage unterhalb der Ausströmöffnung angeordnet. In die nahe einer im eingebauten Zustand unten angeordneten Frontseite der Photovoltaikdachpfanne angeordnete Einströmöffnung strömt dadurch Luft ein, die während des Erwärmens bedingt durch ihre steigende Temperatur innerhalb der Photovoltaikdachpfanne automatisch aufsteigt und somit in Richtung der Ausströmöffnung, die nahe der im Montagezustand oben angeordneten Rückseite der Photovoltaikdachpfanne angeordnet ist, strömt. Dort verlässt die erwärmte Umgebungsluft den Innenraum der Photovoltaikdachpfanne erneut und kann beispielsweise in die nächste Einströmöffnung der benachbarten, oberhalb angeordneten Photovoltaikdachpfanne strömen und dort weiter erwärmt werden.

Die beschriebenen Vorteile hinsichtlich einer optimierten Energieausbeute kommen insbesondere bei Photovoltaikdachpfannen zum Tragen, denn dort wird die aus der Sonnenstrahlung resultierende Energie ansonsten lediglich in Form von elektrischer Energie genutzt. Durch die beschriebene Nutzung der Abwärme des Photovoltaikmoduls wird jedoch die thermische Energie nun ebenfalls vorteilhaft genutzt. Auf der anderen Seite werden dort die Photovoltaikmodule durch die umströmende Umgebungsluft auch von unten, also durch die Umströmung auf ihrer dem Hohlraum zugewandten Innenseite, gekühlt und die entstehende Hitze abgeführt, sodass die Bauteile auch vorteilhaft vor einer Überhitzung geschützt werden. Da im Rahmen dieser Anmeldung nachfolgend insbesondere auf das Beispiel einer Solarenergiedachpfanne in Form einer Photovoltaikdachpfanne eingegangen wird, werden vor allem die Begrifflichkeiten Einströmöffnung für die untere Öffnung und Ausströmöffnung für die obere Öffnung der Solarenergiedachpfanne bzw. Photovoltaikdachpfanne benutzt. Da jedoch durch die Einströmöffnung als untere Öffnung eben auch jener Zugriff in den Hohlraum bereitgestellt werden kann, sowie durch die Ausströmöffnung als obere Öffnung auch der Zugriff in den Hohlraum, können diese Begrifflichkeiten der Öffnungen insbesondere hinsichtlich sämtlicher beschriebenen konstruktiven Vorteile, vor allem in Form von Montagevorteilen, äquivalent verstanden werden. Die nachfolgend beschriebenen konstruktiven Vorteile durch die Einströmöffnung und Ausströmöffnung sind also auch auf andere Solarenergiedachpfannentypen mit den vorschlagsgemäß vorgesehenen, oberen und unteren Öffnungen übertragbar.

Die Form der erfindungsgemäßen Solarenergiedachpfanne entspricht im Wesentlichen der Form einer herkömmlichen Dachpfanne, so dass die äußere Erscheinung eines Daches bzw. eines Hauses durch Verwendung der Solarenergiedachpfanne kaum verändert wird. Der Begriff Dachpfanne ist dabei als Synonym für Dacheindeckungselemente wie Dachziegel, Dachsteine oder Dachschindeln zu verstehen und soll die Erfindung nicht auf Dachpfannen beschränken.

Die erfindungsgemäße Solarenergiedachpfanne weist grundsätzlich die gleichen Abmessungen auf wie eine handelsübliche Dachpfanne ohne Solarenergienutzungsmodul bzw. Photovoltaikmodul.

Zur elektrischen Verbindung mehrerer benachbarter Photovoltaikdachpfannen weist eine Photovoltaikdachpfanne regelmäßig zwei elektrische Verbindungselemente auf. Dabei handelt es sich in der Regel zum einen um ein erstes elektrisches Verbindungselemente in Form eines Steckers und zum anderen um ein zweites elektrisches Verbindungselement in Form einer Buchse. Der Stecker der einen Photovoltaikdachpfanne kann dann zur Herstellung der elektrischen Verbindung in die Buchse der anderen, benachbarten Photovoltaikdachpfanne eingeführt werden, wodurch die elektrischen Kontakte elektrisch leitend miteinander verbunden werden.

Die elektrischen Verbindungselemente sind wiederum an das Photovoltaikmodul angebunden. Das Photovoltaikmodul kann dabei Teil eines sogenannten Glaspaketes sein. Ein Glaspaket kann beispielsweise aus zwei Glasplatten gebildet sein, zwischen denen eine oder mehrere, vorzugsweise aus Siliziumnitrid gebildete, Solarzellen, angeordnet sein können. Diese Solarzellen können wiederum zwischen zwei Folien, beispielsweise aus Ethylen-Vinylacetat (EVA), eingebettet sein. In dem Photovoltaikmodul bzw. in der gesamten Einheit des Glaspakets wird auf bekannte Weise Sonnenstrahlung in elektrische Energie umgewandelt. Die so gewonnene elektrische Energie kann dann über die angebundenen elektrischen Verbindungselemente weitergeleitet und später gezielt genutzt werden. Alternativ können die elektrischen Kontaktflächen aber auch an anderer Stelle der Photovoltaikdachpfanne, also unabhängig von den Verbindungselementen, vorgesehen sein.

Das Photovoltaikmodul ist Teil der Oberseite der Photovoltaikdachpfanne. Die Oberseite ist im montierten Zustand auf dem Dach in Richtung Himmel bzw. Sonne ausgerichtet und wird somit als obere Seite der Photovoltaikdachpfanne angesehen und bezeichnet. Gegenüberliegend der Oberseite ist die Unterseite der Photovoltaikdachpfanne angeordnet. Diese Unterseite liegt auf der Dachkonstruktion des Hauses auf bzw. wird mit dieser verbunden. Beispielsweise liegt die Unterseite einer Photovoltaikdachpfanne auf einer Dachlatte des Daches auf. In dieser Dachlatte ist die Photovoltaikdachpfanne auch regelmäßig zusätzlich mit Verbindungselementen gesichert, beispielsweise indem sie mit einem Nagel oder Schraube mit der regelmäßig aus Holz gebildeten Dachlatte verbunden ist.

Als Rückseite ist die im Montagezustand obere Seitenwand zu verstehen. Die Rückseite der Solarenergiedachpfanne ist somit auf der Dachkonstruktion dem First oder Dachfirst zugewandt. Als Frontseite hingegen ist die gegenüberliegende Seitenwand der Solarenergiedachpfanne zu verstehen. Die Frontseite ist demnach die im Montagezustand untere Seitenwand. Die Frontseite ist auf einem eingedeckten Dach demnach der sogenannten Traufbohle des Daches zugewandt.

Als Seitenwände, Frontseite, Rückseite, sowie auch als Unterseite können einfache Bleche eingesetzt werden. Beispielsweise können die genannten Seiten im Wesentlichen aus Aluminium gebildet sein und es sich somit in vorteilhafter Weise um Leichtbauteile handeln. Dadurch wird die Handhabbarkeit der Dachpfanne erheblich erleichtert. Auch die Herstellung der Solarenergiedachpfanne ist vereinfacht, da die im Wesentlichen senkrecht zueinander angeordneten Bauteile in Form der unterschiedlichen Wände bzw. Bleche beispielsweise einfach ineinandergesteckt und miteinander verbunden, etwa verschraubt oder vernietet, werden können. Alternativ oder ergänzend können beispielsweise auch mehrere Wände durch das Vorsehen eines einzelnen Blechteils ausgebildet sein. So kann die Unterseite ein Blechteil sein, welches die beiden Seitenwände durch Umbiegen der Ränder bereitstellt, oder aber die Front- und/oder die Rückseite sind durch Umbiegen des jeweiligen Endes der als Blech ausgebildeten Unterseite realisiert.

Die Oberseite kann beispielsweise durch eine Abdeckung oder bauliche Einheit ausgebildet sein, die das Solarenergienutzungsmodul bzw. Photovoltaikmodul umfasst. So kann die Oberseite - abgesehen von der Ausströmöffnung - durch ein sogenanntes das Photovoltaikmodul umfassende Glaspaket ausgebildet sein. Der Hohlraum ist dann oberseitig durch das Glaspaket teilweise verschlossen, während die Ausströmöffnung dann dem eben nicht durch das Glaspaket verschlossenen Teil entspricht.

Durch die erfindungsgemäße Solarenergiedachpfanne ist damit sowohl die Herstellung als auch die Montage und Wartung einfach und kostengünstig. Die Montage muss sich dabei nicht sonderlich von der Montage üblicher Dachpfannen unterscheiden. Die Solarenergiedachpfannen können auch ganz einfach an übliche Dachpfannen angebunden werden. Auch die Sicherung an der Dachkonstruktion, beispielsweise an den quer verlaufenden Dachpfannen kann auf übliche Weise erfolgen, indem die Solarenergiedachpfannen mit einem Nagel oder einer Schraube an den Dachlatten gesichert werden. Dieser Nagel oder diese Schraube kann die Solarenergiedachpfanne beispielsweise einfach über eine an die Rückseite angebundene, sich nach unten unter die Unterseite erstreckende Sicherungsplatte an der Dachlatte festlegen.

Ferner können übliche Sicherungselemente zur Verbindung der Solarenergiedachpfannen untereinander, beispielsweise handelsübliche Sturmsogsicherungen, eingesetzt werden. Die sonst zumeist etwas aufwendigere Verbindung der elektrischen Verbindungselemente benachbarter Photovoltaikdachpfannen kann vorliegend ganz einfach dadurch realisiert werden, dass die elektrischen Verbindungselemente durch die Einströmöffnungen bzw. die Ausströmöffnungen der benachbarten Photovoltaikdachpfannen miteinander verbunden werden. Der innerhalb der Photovoltaikdachpfannen vorgesehene Hohlraum kann einfach genutzt werden, um die Verbindungen zu realisieren. Auch kann der Zugang in den Innenraum der Solarenergiedachpfannen, beispielsweise der Photovoltaikdachpfannen, über die Einströmöffnung bzw. über die Ausströmöffnung dazu genutzt werden, die Solarenergiedachpfannen bzw. Photovoltaikdachpfannen zu warten oder weitere Instandhaltungsarbeiten vorzunehmen.

Durch den Hohlraum und die gezielte Wärmeübertragung an die die Solarenergiedachpfannen, etwa die Photovoltaikdachpfannen, durchströmende Luft ist außerdem eine Nutzung der Abwärme möglich. Dadurch kann die Energieeffizienz der mit den erfindungsgemäßen Solarenergiedachpfannen eingedeckten Häuser noch weiter gesteigert werden. Die Energieausbeute ist durch die erfindungsgemäße Solarenergiedachpfanne verbessert.

Die Abmessungen der Einströmöffnung und der Ausströmöffnung können dabei gewählt werden. Bezüglich der sich zwischen den beiden Seitenwänden erstreckenden Dimensionen kann vorzugsweise vorgesehen sein, dass die Einströmöffnung sich im Wesentlichen über die gesamte Breite zwischen den zwei Seitenwänden erstreckt. Auch die Ausströmöffnung kann sich im Wesentlichen über die gesamte Breite zwischen den zwei Seitenwänden erstrecken. Die Einströmöffnung und die Ausströmöffnung können dabei bevorzugt eine gleiche, sich zwischen den zwei Seitenwänden erstreckende Breite aufweisen. Auf diese Weise kann eine optimale Überdeckung der Einströmöffnungen bzw. Ausströmöffnungen benachbarter Solarenergiedachpfannen gewährleistet werden. Außerdem kann ein einfacher Zugang zu dem Innenraum einer Solarenergiedachpfanne gewährleistet werden, was den Aufwand für die Montage sowie für die Wartung gering hält.

In der dazu senkrechten Dimension der Einströmöffnung bzw. Ausströmöffnung, also in der Erstreckung entlang einer von der Frontseite zu der Rückseite verlaufenden Längsrichtung, kann vorgesehen sein, dass die Einströmöffnung entlang einer von der Frontseite zu der Rückseite verlaufenden Längsrichtung eine größere Erstreckung aufweist als die Ausströmöffnung. Dadurch kann sichergestellt werden, dass die somit kleinere Ausströmöffnung einer Solarenergiedachpfanne immer gänzlich in der Überdeckung zu einer darüber liegenden Einströmöffnung einer benachbarten Solarenergiedachpfanne liegt. Somit wird ein sicherer Durchfluss der erwärmten Umgebungsluft von einer Solarenergiedachpfanne zur nächsten gewährleistet.

Die zuvor beschriebenen Eigenschaften der Einströmöffnung bzw. Ausströmöffnung sind können, insbesondere hinsichtlich der Dimensionen und Abmessungen und sich hieraus ergebenden Vorteile, vor allem der Montagevorteile, ganz allgemein auf das Vorsehen der oberen Öffnung in der Oberseite und der unteren Öffnung in der Unterseite in einer Solarenergiedachpfanne übertragen werden.

Gemäß der Erfindung ist vorgesehen, dass die Oberseite eine in einer von der Frontseite zu der Rückseite verlaufenden Längsrichtung verschiebbar ausgebildete Abdeckung aufweist. Dabei kann die Abdeckung durch eine verschiebbare Platte ausgebildet sein, die im aus den Seitenwände bzw. der Front- und der Rückseite gebildeten Rahmen gehalten ist. Die verschiebbare Abdeckung deckt somit nicht die gesamte obere Seite der Solarenergiedachpfanne gänzlich ab, sondern nur teilweise. Ebenfalls ist die Ausströmöffnung in der Oberseite vorgesehen, welche durch die verschiebbare Abdeckung verschoben werden kann, sprich einmal mehr verdeckt und einmal weniger verdeckt werden kann. Somit dann der Hohlraum der Solarenergiedachpfanne an verschiedene Stellen von oben bzw. von außen zugänglich gemacht sein. Auf diese Weise ist der Hohlraum von außen zugänglich gemacht, und zwar nicht nur durch die nahe der Rückseite angeordnete Ausströmöffnung, sondern auch auf der gegenüberliegenden Seite, nahe der Frontseite. Die Abdeckung kann sogar so weit verschiebbar eingerichtet sein, dass die im Bereich der Rückseite angeordnete Ausströmungsöffnung kurzzeitig verschlossen wird und eine Öffnung in der Oberseite im Bereich der Frontseite gebildet wird. Die Abdeckung kann durch ein Glaspaket ausgebildet sein, welches das Solarenergienutzungsmodul, beispielsweise das Photovoltaikmodul, umfasst.

Gemäß einer weiteren bevorzugten Ausführungsform der Solarenergiedachpfanne ist vorgesehen, dass die Unterseite im Wesentlichen durch ein Bodenblech gebildet ist, und dass das Bodenblech im Bereich der unteren Öffnung wenigstens eine Blechlasche, vorzugsweise zwei Blechlaschen, aufweist.

Weiterhin kann vorzugsweise vorgesehen sein, dass sich die Blechlasche in einem Grundzustand der Solarenergiedachpfanne im Wesentlichen parallel zu einer Grundebene des Bodenblechs erstreckt, und dass die Blechlasche in einem Montagezustand der Solarenergiedachpfanne auf einem Dach einen im Wesentlichen senkrecht zur Grundebene verlaufenden Vertikalabschnitt sowie einen an den Vertikalabschnitt anschließenden, im Wesentlichen parallel zur Grundebene verlaufenden Horizontalabschnitt aufweist. Die Grundebene ist dabei die Ebene, die durch den wesentlichen Teil des Bodenblechs gebildet wird. Der Grundzustand der Solarenergiedachpfanne bezieht sich regelmäßig auf den Zustand vor einer Montage. Bei der Montage selbst, kann der Monteur sodann die Blechlasche umbiegen und dabei den Vertikalabschnitt sowie den Horizontalabschnitt vorsehen, der im Montagezustand der Solarenergiedachpfanne vorliegt. Diese Abschnitte können in vorteilhafter Weise zur Herstellung einer Verbindung benachbarter Solarenergiedachpfannen untereinander und somit auch besonders vorteilhaft für eine Sturmsogsicherung sowie auch für einen Potentialausgleich genutzt werden.

Weiterhin kann vorzugsweise vorgesehen sein, dass die Blechlasche mehrere, in regelmäßigen Abständen zueinander angeordnete Bohrungen aufweist. Dies hat Vorteile hinsichtlich der Montage der Solarenergiedachpfannen auf dem Dach, denn auf diese Weise kann die Blechlasche in einfacher Weise mit einer Schraube oder einem Verbindungsmittel versehen werden und etwa über die Blechlasche die Verbindung zu einer darunterliegend angeordneten, benachbarten Solarenergiedachpfanne hergestellt werden.

Gemäß einer weiteren bevorzugten Ausführungsform der Solarenergiedachpfanne ist vorgesehen, dass ein Luftschieber vorgesehen ist, der entlang einer von der Frontseite zu der Rückseite verlaufenden Längsrichtung verschiebbar ausgebildet ist und der derart eingerichtet ist, dass die Einströmöffnung zumindest bereichsweise durch den Luftschieber verschlossen werden kann. Auf diese Weise kann beispielsweise der zuvor beschriebene Größenunterschied zwischen Einströmöffnung und Ausströmöffnung erneut ausgeglichen werden. Denn die die Größe bzw. Lage der Einströmöffnung ist somit veränderlich ausgebildet. Der Luftschieber kann auf der dem Hohlraum zugewandten Innenseite der Unterseite aufliegend ausgebildet sein. Der Luftschieber kann dann entlang dieser Innenseite der Unterseite verschoben werden. Dadurch kann die Einströmöffnung mal mehr oder mal weniger verdeckt werden. Es ist auch denkbar, dass die Einströmöffnung gar nicht durch den Luftschieber verdeckt wird, wenn der Luftschieber entlang der Längsrichtung gänzlich bis hinter die Einströmöffnung verschoben ist. In einem montierten Zustand, wenn zwei benachbarte Solarenergiedachpfannen derart angeordnet sind, dass die Ausströmöffnung der einen Solarenergiedachpfanne in Übereinstimmung mit der Einströmöffnung der anderen Solarenergiedachpfanne gebracht ist, können die beiden Öffnungen durch den Luftschieber besser zueinander in Übereinstimmung bzw. in Einklang gebracht werden. Dadurch, dass die Einströmöffnung durch den Luftschieber veränderlich ausgebildet ist, kann die Einströmöffnung der einen Solarenergiedachpfanne an die Ausströmöffnung der im Montagezustand darunter liegenden Solarenergiedachpfanne angepasst werden. Auf diese Weise können Längenunterschiede ausgeglichen werden, die zwangsläufig bei verschiedenen Dachkonstruktionen vorliegen können. So können Dachlatten unter Umständen nicht einen regelmäßigen Abstand zueinander aufweisen, sondern ein paar Zentimeter mehr oder weniger voneinander beabstandet sein. Sodann könnte es passieren, dass eine im Montagezustand oberhalb angeordnete, obere Solarenergiedachpfanne gegenüber der unterhalb angeordneten, unteren Solarenergiedachpfanne zu weit weg liegt, sodass die Einströmöffnung der oberen Solarenergiedachpfanne nicht nur durch die Ausströmöffnung der unteren Solarenergiedachpfanne angeströmt würde, sondern auch durch andere, von außen einströmende Luft. Dies könnte jedoch nachteilig sein, wenn sich die angeströmte Luft zwar bereits erwärmt hat jedoch dann mit kälterer Luft, die durch die zu große bzw. nicht perfekt in Einklang gebracht Einströmöffnung der oberen Solarenergiedachpfanne eindringt, vermischt. Daher kann der verstellbare Luftschieber auch für einen optimalen Wärmeübergang sorgen und somit die Energienutzung bzw. Energieeffizienz des Systems verbessern.

Eine bevorzugte Ausführungsform der Solarenergiedachpfanne ist dadurch gekennzeichnet, dass der Luftschieber einen im Wesentlichen parallel zur Unterseite verlaufenden Basisabschnitt aufweist, dass der Luftschieber einen sich von dem Basisabschnitt im Wesentlichen senkrecht nach oben in Richtung Oberseite erstreckenden Ansatzabschnitt aufweist, und dass in dem Ansatzabschnitt eine der Rückseite zugewandte Durchgangsöffnung vorgesehen ist. Dadurch ist der Luftschieber auf einfache Weise entlang der Unterseite der Solarenergiedachpfanne verschiebbar ausgebildet, wenn der Basisabschnitt auf der Unterseite aufliegt. Es können auch seitliche Führungs- bzw. Roll- oder Gleitelemente vorgesehen sein, die die Führung des Luftschiebers unterstützen. Über den Ansatzabschnitt wird eine Angriffsfläche an den Luftschieber bereitgestellt, die es ermöglicht, den Luftschieber einfach entlang der Längsrichtung zu verschieben. Die Durchgangsöffnung kann dafür genutzt werden, weitere Bauteile, wie beispielsweise der später beschriebenen Sturmsogsicherung mit der sich durch den Hohlraum erstreckenden Welle, mit dem Luftschieber zu verbinden bzw. die Bewegungen des weiteren Bauteils und des Luftschiebers miteinander zu koppeln. Vorzugsweise kann der Luftschieber einen an den Ansatzabschnitt anschließenden und weg von dem Basisabschnitt erstreckenden Dachabschnitt aufweisen sowie ferner einen Sicherungsabschnitt aufweisen, wobei vorzugsweise in dem Sicherungsabschnitt eine der Frontseite zugewandte Durchgangsöffnung vorgesehen ist. Dadurch entsteht eine muldenartige Aufnahme zwischen Ansatzabschnitt, Dachabschnitt und Sicherungsabschnitt des Luftschiebers. Diese Aufnahme dient beispielsweise der Aufnahme weiterer Elemente, wie beispielsweise eines Hakenelementes der eine sich durch den Hohlraum erstreckende Welle aufweisenden Sturmsogsicherung, wie später erläutert wird. Dadurch kann auf einfache Weise die Bewegung des weiteren Elementes bzw. der Sturmsogsicherung mit der des Luftschiebers gekoppelt werden. Außerdem kann die muldenartige Aufnahme einen Aufnahmeraum bzw. Schutz für weitere Elemente, beispielsweise eines Hakenelementes der später beschriebenen, eine sich durch den Hohlraum erstreckende Welle aufweisenden Sturmsogsicherung, dienen.

Die erfindungsgemäße Solarenergiedachpfanne kann mit einer Sturmsogsicherung versehen werden, die beispielsweise mit einer benachbarten Solarenergiedachpfanne verbindbar ist, um die Solarenergiedachpfannen auf einem Dach zu sichern. Sturmsogsicherungen, die auch als Windsogsicherungen bezeichnet werden, dienen dazu, das Abdecken des Daches durch Sturm (Windsog) zu verhindern. Dies wird typischerweise durch Anbringen eines Drahtes bzw. einer Klammer an der Dachpfanne realisiert, der diese an der Dachlatte verankert. Das Verankern ist vergleichsweise zeitraubend, es braucht je nach Gegebenheiten vor Ort manchmal mehr Zeit als das Decken der Dachpfanne selbst. Darüber hinaus ist es äußerst schwierig, eine solche Dachpfanne (wenn sie z.B. schadhaft ist) im Dachverbund (komplett eingedecktes Dach) zu tauschen. Die erfindungsgemäße Solarenergiedachpfanne kann mit handelsüblichen Sturmsogsicherungen gesichert werden. Alternativ stellt die vorliegende Erfindung auch nachfolgend beschriebene neue Konzepte für eine Sturmsogsicherung zur Verfügung.

Gemäß einer besonders bevorzugten Ausführungsform der Solarenergiedachpfanne ist vorgesehen, dass eine mit einer benachbarten Solarenergiedachpfanne verbindbare Sturmsogsicherung vorgesehen ist, wobei die Sturmsogsicherung eine sich durch den Hohlraum von der Rückseite in Richtung der Frontseite bis wenigstens in den Bereich der Einströmöffnung erstreckende Welle aufweist. Die Sturmsogsicherung weist ferner dabei an ihrem der Einströmöffnung zugeordneten Ende ein Hakenelement mit einer Einführspitze auf. Die Sturmsogsicherung weist ferner an ihrem gegenüberliegenden, der Ausströmöffnung zugeordneten Ende eine Aufnahmeöffnung zur Aufnahme einer Einführspitze einer weiteren Sturmsogsicherung einer benachbarten Solarenergiedachpfanne auf. Die derart ausgebildete und mit der Solarenergiedachpfanne verbundene Sturmsogsicherung erstreckt sich somit in einer von der Frontseite bis zur Rückseite verlaufenden Längsrichtung gesehen von vorne bis hinten durch die Solarenergiedachpfanne. Die Sturmsogsicherung weist einseitig eine Aufnahmeöffnung auf und auf der gegenüberliegenden Seite ein Hakenelement mit einer Einführspitze. Bei dieser Einführspitze kann es sich um ein Stift, ein Bolzenelement, einen Nagel, einen Dorn oder dergleichen handelt. Diese Einführspitze ist in die entsprechende Aufnahmeöffnung einer anderen, beispielsweise benachbarten Sturmsogsicherung einführbar. Dadurch, dass mehrere solcher, jeweils eine sich durch den Hohlraum erstreckende Welle aufweisende Sturmsogsicherungen von mehreren, benachbarten Solarenergiedachpfannen miteinander verbunden, und zwar auf einfache Weise ineinandergesteckt, werden können, können die benachbarten Solarenergiedachpfannen auf einfache Weise auch untereinander verbunden und somit gesichert werden.

Einer solchen verwendeten, eine sich durch den Hohlraum erstreckende Welle aufweisenden Sturmsogsicherung gemäß den vorstehend beschriebenen Merkmalen kommt für sich genommen eigene erfinderische Bedeutung zu. Auch andere Dachpfannen als die erfindungsgemäße Solarenergiedachpfanne können mit der beschriebenen Sturmsogsicherung ausgerüstet werden. Insofern kann die Sturmsogsicherung als Nachrüstbauteil vorgesehen sein. Die Sturmsogsicherung muss dazu an die Dachpfanne angebunden werden, sodass einseitig die Aufnahmeöffnung der Sturmsogsicherung und auf der gegenüberliegenden Seite das Hakenelement mit der Einführspitze vorgesehen ist. Dann können auch handelsübliche Dachpfannen mit der beschriebenen Sturmsogsicherung untereinander verbunden und somit gegen Abdecken gesichert werden. Vorzugsweise sind dann nur noch die Dachpfannen selbst oder manche der Dachpfanne an den Dachlatten festzulegen, beispielsweise auf übliche Weise mittels Vernagelns oder auch Festschrauben in der Holz-Dachlatte, und sodann sorgt die Verbindung der beschriebenen Sturmsogsicherung untereinander für ein Verhindern eines Abdeckens des Daches. Die beschriebene, eine sich durch den Hohlraum erstreckende Welle aufweisende Sturmsogsicherung ist demnach ebenfalls neu und vorteilhaft.

Dies trifft auch auf die nachfolgend beschriebenen Merkmale der eine sich durch den Hohlraum erstreckende Welle aufweisenden Sturmsogsicherung zu. Solchen, nachfolgend beschriebenen Sturmsogsicherungen kommt ebenfalls für sich genommen eigene erfinderische Bedeutung zu. Insofern treffen die zuvor und nachfolgend beschriebenen Vorteile hinsichtlich der Solarenergiedachpfanne, insbesondere derer Montage, teilweise auch auf andere Dachpfannen zu, die mit einer solchen neuen und vorteilhaften Sturmsogsicherung ausgestattet werden.

Die Einführspitze der beschriebenen, eine sich durch den Hohlraum erstreckende Welle aufweisenden Sturmsogsicherung ist beispielsweise durch einen Nagel ausgebildet, der durch eine Durchgangsbohrung durch einen Grundkörper des Hakenelementes geführt ist. Dadurch ist die Montage der Sturmsogsicherung bzw. der entsprechenden Dachpfannen vereinfacht, denn der Nagel kann auch erst vor Ort durch die Durchgangsbohrung geführt werden, um den Formschluss der benachbarten Sturmsogsicherungen und somit der benachbarten Dachpfannen herzustellen.

Eine bevorzugte Ausführungsform der eine sich durch den Hohlraum erstreckende Welle aufweisenden Sturmsogsicherung ist dadurch gekennzeichnet, dass das Hakenelement entlang der Welle längsverschiebbar ausgebildet ist oder dass die Welle als längsverschiebbare Teleskopwelle ausgebildet ist. Das Hakenelement kann dazu beispielsweise eine Bohrung aufweisen, durch die sich die Welle erstreckt und durch welche das Hakenelement längsverschiebbar mit der Welle verbunden ist. Alternativ kann das Hakenelement auch nicht längsverschiebbar auf der Welle gesichert, beispielsweise aufgepresst, sein. Dann kann die Welle als Teleskopwelle oder auch Trompetenrohr ausgebildet sein. Bei einem solchen Trompetenrohr können sich zwei oder mehrere Rohrabschnitte unterschiedlichen Durchmessers ineinander verschieben. Dadurch kann die Lage des Hakenelementes und somit der damit verbundenen Einführspitze entlang der Längsrichtung veränderlich sein. Somit wird die Montage der Solarenergiedachpfanne erheblich vereinfacht. Denn eine unterhalb bereits auf dem Dach aufliegende Solarenergiedachpfanne muss mit einer darüber zu montierenden Solarenergiedachpfanne derart in Übereinstimmung gebracht werden, dass die Einführspitze der oberen Sturmsogsicherung in die Aufnahmeöffnung der unteren Sturmsogsicherung eingeführt wird. Dazu ist vorliegend vorteilhaft, wenn die Einführspitze der oberen Sturmsogsicherung kurz zwecks Montage entlang der Welle bzw. mitsamt der (Teleskop-)Welle zurück verschoben wird und dann, wenn die obere Solarenergiedachpfanne mit der oberen Sturmsogsicherung ausgerichtet ist, wieder ausgefahren und mit der Aufnahmeöffnung der unteren Sturmsogsicherung in Formschluss gebracht wird.

Gemäß einer weiteren bevorzugten Ausführungsform der eine sich durch den Hohlraum erstreckende Welle aufweisenden Sturmsogsicherung ist vorgesehen, dass eine um die Welle angeordnete Druckfeder vorgesehen ist, die das Hakenelement in einer in Richtung der Frontseite verschobenen Position hält. Dadurch wird die Montage der Solarenergiedachpfannen auf einem Dach weiter vereinfacht. Die Druckfeder drängt nämlich die Einführspitze automatisch in die Aufnahmeöffnung der im Montagezustand darunter angeordneten, benachbarten und ebenfalls eine sich durch den Hohlraum erstreckende Welle aufweisenden Sturmsogsicherung. Unter einer um die Welle angeordneten Druckfeder kann zu verstehen sein, dass die Druckfeder um die Welle herum gewickelt ist. Die Welle erstreckt sich dann zentral durch die Druckfeder hindurch. Dabei kann die Druckfeder an das auf der Welle angeordnete Hakenelement anschließen. Eine Verschiebung des Hakenelementes auf der Welle kann somit die Druckfeder komprimieren.

Die eine sich durch den Hohlraum erstreckende Welle aufweisende Sturmsogsicherung kann an ihrem der Rückseite zugeordneten Ende an der Rückseite festgelegt ist. Dabei kann die Welle der Sturmsogsicherung beispielsweise an die Rückseite angebunden sein. Lediglich die Aufnahmeöffnung der Sturmsogsicherung ist dabei freiliegend, damit die Einführspitze einer darüber angeordneten Sturmsogsicherung erneut in diese Aufnahmeöffnung eingeführt werden kann. Es können zusätzliche Sicherungselemente vorgesehen sein, um die Sturmsogsicherung an der Rückseite festzulegen.

Ferner kann sich die eine sich durch den Hohlraum erstreckende Welle aufweisende Sturmsogsicherung, insbesondere mit der Welle, wenigstens durch die der Rückseite zugewandte Durchgangsöffnung, vorzugsweise weiterhin auch durch die der Frontseite zugewandte Durchgangsöffnung, erstrecken. Auf diese Weise ist eine einfache Anbindung der Sturmsogsicherung an die Solarenergiedachpfanne gewährleistet. Auch die Bewegung bzw. Verschiebung der Sturmsogsicherung bzw. die Längsverschiebung des Hakenelementes der Sturmsogsicherung kann somit auf einfache Weise mit einer Verschiebung des Luftschiebers gekoppelt sein. Die Ausrichtung der übereinander liegenden Einströmöffnung und Ausströmöffnung von zwei benachbarten Solarenergiedachpfannen kann somit auf einfache Weise erfolgen.

Eine bevorzugte Ausführungsform der eine sich durch den Hohlraum erstreckende Welle aufweisenden Sturmsogsicherung ist dadurch gekennzeichnet, dass die Welle um ihre Längsachse drehbar ausgebildet ist und/oder dass das Hakenelement um die Welle herum drehbar ausgebildet ist. Auf eine solche Weise kann ein weiterer Freiheitsgrad für die Lage des Hakenelementes und somit der Einführspitze zur Verfügung gestellt werden. Das Hakenelement kann in einem Grundzustand beispielsweise seitlich verschwenkt sein und im Wesentlichen parallel zur Unterseite der Solarenergiedachpfanne angeordnet sein. Zwecks einer Montage auf dem Dach kann dann dieses Hakenelement aus dieser Position herausgeschwenkt werden und nach unten von der Unterseite der Solarenergiedachpfanne hervorstehen. Auf diese Weise kann das Hakenelement mit seiner Einführspitze dann einfach mit der Aufnahmeöffnung der darunter liegenden Sturmsogsicherung in Eingriff gebracht werden.

Gemäß einer weiteren bevorzugten Ausführungsform der eine sich durch den Hohlraum erstreckende Welle aufweisenden Sturmsogsicherung ist vorgesehen, dass eine der Rückseite zugewandte Seite des Hakenelementes wenigstens teilweise an einer der Frontseite zugewandten Seite des Ansatzabschnittes anliegt. Auf diese Weise wird eine besonders einfache Montage der Solarenergiedachpfannen ermöglicht. Denn die der Rückseite zugewandte Seite des Hakenelementes sorgt bei einer Längsverschiebung des Hakenelementes auch automatisch für eine Verschiebung des Luftschiebers über den Ansatzabschnitt. Auf diese Weise wird daher eine einfache Kopplung zwischen der Verschiebung des Hakenelementes und des Luftschiebers erzielt.

Alternativ zu der beschriebenen, eine sich durch den Hohlraum erstreckende Welle aufweisenden Sturmsogsicherung können die vorschlagsgemäßen Solarenergiedachpfanne besonders vorteilhaft eine andere, einfache Sturmsogsicherung aufweisen. Die zuvor ebenfalls beschriebene Blechlasche bzw. Blechlaschen im Bodenblech der Unterseite können nämlich auf die beschriebene Weise auch der Sturmsogsicherung dienen, da hierüber oberhalb und unterhalb benachbarte Solarenergiedachpfannen miteinander mechanisch verbunden werden können. Darüber hinaus kann auch in vorteilhafter Weise ein bodenblechseitiges Sturmsogsicherungselement, oder noch vorteilhafter zwei bodenblechseitige Sturmsogsicherungselemente, vorgesehen sein. Diese bodenblechseitigen Sturmsogsicherungselemente können als Nagel oder bevorzugt als Schraube ausgebildet sein. Die bodenblechseitigen Sturmsogsicherungselemente können die Unterseite der Solarenergiedachpfanne bzw. das Bodenblech im Montagezustand direkt an der darunter liegenden Dachlatte des Daches festlegen. Durch die vorteilhaften Öffnungen in Form der oberen Öffnung in der Oberseite und der unteren Öffnung in der Unterseite der vorschlagsgemäßen Solarenergiedachpfanne können diese bodenblechseitigen Sturmsogsicherungselementen auch einfach von oben zugänglich erreicht und in der Dachlatte montiert, oder aber auch wieder demontiert werden. Die entsprechende Solarenergiedachpfanne wird somit durch die bodenblechseitigen Sturmsogsicherungselemente an der Dachlatte und gegen, beispielsweise sturmbedingte, Abdeckung gesichert. Insbesondere in Kombination mit der Verbindung benachbarter Solarenergiedachpfannen über die zuvor beschriebenen Blechlaschen kann auf diese Weise ein besonders sicheres, sturmfestes System an Solarenergiedachpfannen auf einem Dach bereitgestellt werden. Für die bodenblechseitigen Sturmsogsicherungselemente können in vorteilhafter Weise bereits Bohrungen in der Unterseite bzw. im Bodenblech der Solarenergiedachpfanne vorgesehen sein.

Eine bevorzugte Ausführungsform der Solarenergiedachpfanne ist dadurch gekennzeichnet, dass die Frontseite schwenkbar ausgeführt ist, sodass im Montagezustand ein Zugang von außen in den Hohlraum vorhanden ist. Auf diese Weise kann die Wartung und auch die Montage der Solarenergiedachpfannen weiter vereinfacht werden. So kann beispielsweise die elektrische Verbindung von Stecker- und Buchselementen über den Zugang der heruntergeklappten Frontseite einfach von außen erledigt werden. Auch Instandhaltungsmaßnahmen oder optische Kontrollen können durch diesen Zugang von außen einfach erledigt werden.

Zur angesprochenen elektrischen Verbindung benachbarter Solarenergiedachpfannen bzw. insbesondere Photovoltaikpfannen kann beispielsweise ein erstes elektrisches Verbindungselement auf einer dem Hohlraum zugewandten Seite der Frontseite befestigt sein. Auf diese Weise werden die Montage und Demontage weiter vereinfacht. Denn die elektrische Verbindung zwischen Solarenergiedachpfannen bzw. Photovoltaikdachpfannen kann einfach hergestellt und wieder gelöst werden, da die Verbindungen von außen einfach zugänglich sind.

Weiterhin kann ein zweites elektrisches Verbindungselement im Bereich der Ausströmöffnung angeordnet sein, wobei das zweite elektrische Verbindungselement zur Verbindung mit dem ersten Verbindungselement einer benachbarten Solarenergiedachpfanne bzw. Photovoltaikdachpfanne eingerichtet sein kann. Auf diese Weise werden die Montage und Demontage noch weiter vereinfacht. Denn die elektrische Verbindung zwischen Solarenergiedachpfannen bzw. Photovoltaikdachpfannen kann einfach hergestellt und wieder gelöst werden, da die Verbindungen von außen einfach zugänglich sind.

Das erfindungsgemäße Solarenergiesystem dient der Gewinnung von Energie aus Sonnenstrahlung. Es kann auch noch der gleichzeitigen Nutzung der Abwärme dienen. Das erfindungsgemäße Solarenergiesystem weist wenigstens zwei miteinander verbundene erfindungsgemäße Solarenergiedachpfannen auf, wobei die obere Öffnung der im Montagezustand unterhalb angeordneten Solarenergiedachpfanne wenigstens teilweise mit der unteren Öffnung der im Montagezustand oberhalb angeordneten Solarenergiedachpfanne in Übereinstimmung gebracht ist.

Auf diese Weise wird ein System bereitgestellt, mittels welchem ein Dach mit den erfindungsgemäßen Solarenergiedachpfannen derart eingedeckt werden kann, dass nicht nur die Sonnenstrahlung erfolgreich zur Generierung etwa elektrischer oder auch thermischer Energie genutzt wird, sondern gleichzeitig auch noch die Abwärme technisch im Haushalt auf einfache Weise genutzt wird. Die zuvor im Zusammenhang mit den erfindungsgemäßen Solarenergiedachpfannen beschriebenen Vorteile treffen insofern auch auf das erfindungsgemäße Solarenergiesystem zu.

Unter einem Solarenergiesystem kann insbesondere ein Photovoltaiksystem verstanden werden. Auch ein Solarthermiesystem kann hierunter verstanden werden. Ebenso kann eine Kombination der Techniken Photovoltaik und Solarthermie in einem Solarenergiesystem zum Einsatz kommen.

Regelmäßig wird ein Dach derart eingedeckt, dass zuerst eine im Montagezustand unten liegende Solarenergiedachpfanne auf der Dachkonstruktion festgelegt wird, beispielsweise mittels eines Nagels oder einer Schraube in einer Dachlatte gesichert wird. Die Solarenergiedachpfannen kann jedoch auch einfach an eine Dachlatte gehängt werden, indem beispielsweise eine oder mehrere rückseitige Lattenhalterungen, die unterhalb der Unterseite der Dachpfanne hervorragen, von oben an der Dachlatte verhakt werden. Die Sicherung mittels Nagels oder Schraube in der Dachlatte ist also nicht unbedingt notwendig, bzw. kann auch bedarfsweise später erfolgen. Daraufhin wird eine weitere Solarenergiedachpfanne oberhalb der vorherigen angebracht. Die Verbindung kann dann vorteilhaft zwischen beiden hergestellt werden, indem beispielsweise das Hakenelement der eine sich durch den Hohlraum erstreckende Welle aufweisenden Sturmsogsicherung der oberen Solarenergiedachpfanne mit der Aufnahmeöffnung der eine sich durch den Hohlraum erstreckende Welle aufweisenden Sturmsogsicherung der unteren Solarenergiedachpfanne in Eingriff gebracht wird. Dies sowie das Herstellen der elektrischen Verbindungen können in vorteilhafter Weise auch über die obere Öffnung bzw. die Ausströmöffnung der oberen Solarenergiedachpfanne durchgeführt werden. Auch die alternativ beschriebene Sturmsogsicherung kann zum Einsatz kommen, indem beispielsweise die Blechlasche der oberen Solarenergiedachpfanne mit der Unterseite oder dem Bodenblech der unteren Dachpfanne, vorzugsweise über die Potentialausgleichselemente, verbunden werden. Auch die bodenblechseitigen Sturmsogsicherungselemente können vorgesehen und in der Dachlatte gesichert werden. Diese Montagetätigkeiten in Form des Vorsehens der Potentialausgleichselemente sowie der bodenblechseitigen Sturmsogsicherungselemente werden durch die vorhandenen oberen Öffnungen bzw. Ausströmöffnungen sowie unteren Öffnungen bzw. Einströmöffnung erheblich vereinfacht.

Eine bevorzugte Ausführungsform des Solarenergiesystems ist dadurch gekennzeichnet, dass an die obere Öffnung der im Montagezustand zuoberst angeordneten Solarenergiedachpfanne anschließend ein Verbraucher, insbesondere in Form einer Wärmepumpe oder eines Wärmetauschers, vorgesehen ist, der die durch die erwärmte Umgebungsluft zur Verfügung gestellte Wärmeenergie nutzt. Dadurch ist ein System bereitgestellt, dass die mittels Sonnenstrahlung zur Verfügung gestellte Energie noch besser ausnutzt.

Beispielsweise schließt der First bzw. Dachfirst an die auf einem Dach zuoberst angeordneten Solarenergiedachpfannen an. In dem Dachfirst kann dann ein Hohlraum vorgesehen sein, welcher mit der oberen Öffnung bzw. Ausströmöffnung der obersten Solarenergiedachpfanne in Übereinstimmung gebracht ist. Der Rand des Dachfirstes schließt die oberste obere Öffnung bzw. Ausströmöffnung zur Umgebung hin dicht ab. Nach innen hin, in Richtung des Hauses, wird die erwärmte Umgebungsluft dann durch den Hohlraum des Dachfirstes abgesaugt und etwa in dem Haus genutzt. Es können auch zusätzliche Gebläseelemente vorgesehen sein. Diese können beispielsweise auch in unteren Solarenergiedachpfannen vorgesehen sein und aktiv dafür Sorge tragen, dass die durch die Solarenergiedachpfanne strömende und sich dabei erwärmende Luft weiter nach oben in Richtung Dachfirst geleitet wird. Unterhalb der im Montagezustand zuunterst angeordneten Solarenergiedachpfanne kann auch ein Lochblech vorgesehen sein, welches die untere Öffnung bzw. Einströmöffnung abdeckt. Dadurch ist zwar zum einen das gewünschte Ansaugen bzw. Durchströmen der Umgebungsluft gewährleistet, es wird jedoch zum anderen verhindert, dass ungewollte Gegenstände oder gar Tiere in den Hohlraum der Solarenergiedachpfannen gelangen. Insbesondere in der im Montagezustand zuunterst angeordneten Solarenergiedachpfanne oder außerhalb dieser kann auch ein Ansaugelement bzw. Gebläseelement vorgesehen sein, das dafür Sorge trägt, dass Umgebungsluft in den Hohlraum dieser Solarenergiedachpfanne eintritt. In dem Dachfirst kann auch eine Klappe vorgesehen sein, um die erwärmte durch die Solarenergiedachpfannen geströmte Umgebungsluft bei Bedarf auch erneut an die Umgebung abgeben zu können. Die Klappe kann manuell bedienbar oder auch automatisch gesteuert werden. Diese Klappe kann beispielsweise geöffnet werden, wenn ansonsten zu viel Wärme durch die erwärmte Umgebungsluft bereitgestellt werden würde, die gar nicht im Haushalt genutzt werden kann.

Gemäß einer weiteren Ausführungsform des Solarenergiesystems kann vorgesehen sein, dass ein Potentialausgleichselement vorgesehen ist, welches Potentialausgleichselement sich zumindest teilweise wenigstens durch die beiden Unterseiten der wenigstens zwei miteinander verbundenen Solarenergiedachpfannen erstreckt, wobei vorzugsweise das Potentialausgleichselement derart angeordnet ist, dass das Potentialausgleichselement das Bodenblech der im Montagezustand unterhalb angeordneten Solarenergiedachpfanne mit der Blechlasche der im Montagezustand oberhalb angeordneten Solarenergiedachpfanne miteinander verbindet. Dieses Potentialausgleichselement kann beispielsweise als Schraube oder auch als Nagel ausgebildet sein. Es dient einerseits der mechanischen Verbindung benachbarter Solarenergiedachpfannen. Auf diese Weise dient es auch der Sturmsogsicherung. Weiterhin kann es benachbarte Solarenergiedachpfannen insbesondere im Bereich ihrer Bodenbleche derart miteinander verbinden, dass die Gehäuse der benachbarten Solarenergiedachpfannen hierüber elektrisch leitend miteinander verbunden sind. Hierzu kann etwa sowohl das Bodenblech als auch die Blechlasche als auch das Potentialausgleichselement metallisch ausgebildet sein. Hierdurch wird ein Potentialausgleich gewährleistet und es kann beispielsweise schließlich eine Erdung bereitgestellt werden.

Das erfindungsgemäße Verfahren dient der Gewinnung von Energie aus Sonnenstrahlung und gleichzeitiger Nutzung der Abwärme. Bei dem erfindungsgemäßen Verfahren wird mittels einer, vorzugsweise erfindungsgemäßen, Solarenergiedachpfanne mithilfe eines Solarenergienutzungsmoduls aus Sonnenstrahlung thermische und/oder elektrische Energie hergestellt und die dabei durch eine Erwärmung des Solarenergienutzungsmoduls entstehende Abwärme an vorbeiströmende Umgebungsluft abgegeben und die sich erwärmte Umgebungsluft einem Verbraucher, insbesondere in Form einer Wärmepumpe oder eines Wärmetauschers, zugeführt.

Dadurch wird ein Verfahren bereitgestellt, das noch effektiver die durch Sonnenstrahlung zur Verfügung gestellte Energie nutzt. So wird nicht lediglich in einem Solarenergienutzungsmodul wie etwa bei einem Photovoltaikmodul einer Photovoltaikdachpfanne elektrische Energie bzw. Strom gewonnen, sondern es wird zeitgleich auch die Abwärme der sich erhitzenden Photovoltaikmodule genutzt und bedarfsgerecht eingesetzt. Die zuvor beschriebenen Vorteile hinsichtlich der erfindungsgemäßen Photovoltaikdachpfanne treffen entsprechend, insbesondere bei Verwendung der erfindungsgemäßen Photovoltaikdachpfanne, auch auf das erfindungsgemäße Verfahren zu.

Eine bevorzugte Ausführungsform des Verfahrens ist dadurch gekennzeichnet, dass mehrere erfindungsgemäße Solarenergiedachpfannen, vorzugsweise in einem erfindungsgemäßen Solarenergiesystem, vorgesehen sind und auf einer Dachkonstruktion montiert werden, dass Umgebungsluft durch die im Montagezustand zuunterst angeordnete Solarenergiedachpfanne angesaugt wird, dass die angesaugte Umgebungsluft über die Ausströmöffnung und Einströmöffnung jeweils benachbarter Solarenergiedachpfannen durch die Hohlräume der benachbarten Solarenergiedachpfannen geführt wird, und dass die erwärmte Umgebungsluft von der im Montagezustand zuoberst angeordneten Solarenergiedachpfanne abgesaugt und einem Verbraucher zugeführt wird. Unter benachbarten Dachpfannen sind hier erneut oberhalb und unterhalb benachbarte Dachpfannen zu verstehen. Die durch die Sonnenstrahlung zur Verfügung gestellte Energie wird dadurch zielgerecht ausgenutzt sowohl zur Gewinnung elektrischer Energie in Form von Strom als auch zur Nutzung von Wärme. Dabei kann sowohl das Ansaugen als auch das Absaugen bzw. Abpumpen von der Umgebungsluft, einmal als kältere Luft und dann als erwärmte Luft, passiv und auch aktiv erfolgen. Es können also zusätzliche Ansaug- und/oder Abpumpelemente vorgesehen sein, die das Ansaugen und Weiterleiten der Umgebungsluft unterstützen. Das Durchströmen der Solarenergiedachpfannen mittels Umgebungsluft kann jedoch auch rein passiv realisierbar sein. So kann der Effekt positiv ausgenutzt werden, dass die sich in der untersten Solarenergiedachpfanne erwärmende Umgebungsluft automatisch nach oben steigt und somit in Richtung der Ausströmöffnung der untersten Solarenergiedachpfanne strömt. Darüber gelangt die sich erwärmende Umgebungsluft sodann in die zunächst darüber angeordnete Solarenergiedachpfanne, wo sich die erwärmte Umgebungsluft weiter aufheizt, usw.

Die Erfindung wird anhand der nachfolgenden Figuren näher erläutert. Diese zeigen ein bevorzugtes Ausführungsbeispiel der Erfindung, das die Erfindung aber nicht auf die gezeigten Merkmale beschränken soll. Es zeigen:
- Figur 1:: eine erfindungsgemäße Solarenergiedachpfanne in Form einer Photovoltaikdachpfanne in Explosionsdarstellung,
- Figur 2:: die Photovoltaikdachpfanne aus Figur 1 in einem zusammengebauten Zustand in Draufsicht,
- Figur 3:: die Photovoltaikdachpfanne gemäß Figur 2 in einer perspektivischen Ansicht von unten,
- Figur 4:: die Photovoltaikdachpfanne gemäß Figur 2 in einer Seitenansicht,
- Figur 5:: die Photovoltaikdachpfanne gemäß Figur 2 in einer Frontansicht,
- Figur 6:: die Photovoltaikdachpfanne gemäß Figur 5 im Längsschnitt, entsprechend der Schnittlinien A-A, wobei zusätzlich eine Detailvergrößerung gezeigt ist,
- Figur 7:: eine erfindungsgemäße Solarenergiedachpfanne in Form einer Photovoltaikdachpfanne in Explosionsdarstellung,
- Figur 8: ein Auszug eines mit Solarenergiedachpfannen in Form von Photovoltaikdachpfannen eingedeckten Daches in Draufsicht,
- Figur 9: ein weiteres Ausführungsbeispiel einer vorschlagsgemäßen Solarenergiedachpfannen in Form einer Photovoltaikdachpfanne,
- Figur 10: das Ausführungsbeispiel gemäß Figur 9, in einem Montagezustand dargestellt,
- Figur 11: Seitenansichten der Darstellungen aus Fig. 9 (in der Ansicht a) der Fig. 11), sowie aus Fig. 10 (in der Ansicht b) der Fig. 11), und
- Figur 12: eine Seitenansicht von mehreren benachbarten Photovoltaikdachpfannen gemäß Fig. 8 bis 11 in einem auf einem Dach montierten Zustand (in der Ansicht a) der Fig. 12), auch in einer vergrößerten Detailansicht B (in der Ansicht b) der Fig. 12).

Nachfolgend wird die Erfindung am Beispiel einer Photovoltaikdachpfanne diskutiert. Die Erfindung ist jedoch nicht auf diesen Solarenergiedachpfannentyp beschränkt. Die Vorteile ergeben sich insbesondere auch bei Solarthermiedachpfannen sowie auch bei kombinierten Dachpfannen, die Photovoltaik und Solarthermie nutzen. Insbesondere sind die nachfolgenden auf die Herstellung von elektrischen Verbindungen bei Photovoltaikdachpfannen bezogenen Vorteile auch auf die Herstellung von thermischen Verbindungen zwischen benachbarten Solarthermiedachpfannen übertragbar. Bei Solarthermiedachpfannen sind anstelle elektrischer Leitungen Fluidleitungen vorgesehen. Entsprechend sind anstelle von elektrischen Verbindungen Kupplungselemente für die Verbindung der fluidführenden Leitungen notwendig, die analog zu den elektrischen Verbindungen bei der Verlegung der Dachpfannen miteinander verbunden werden.

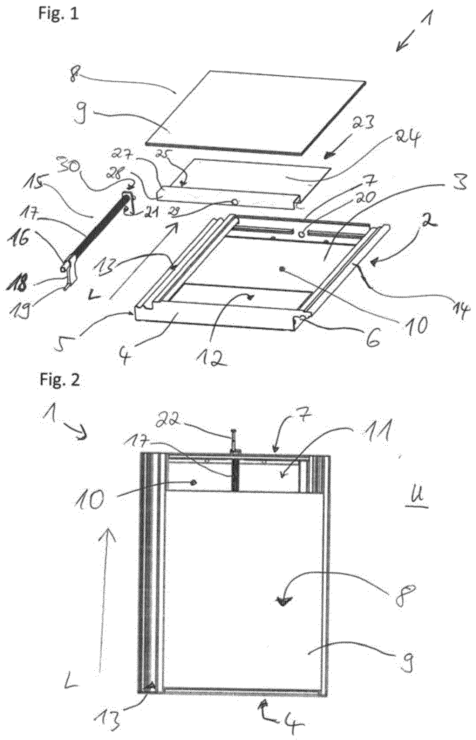

Figur 1 zeigt eine bevorzugte Ausführung einer erfindungsgemäßen Photovoltaikdachpfanne 1 in einer Explosionsdarstellung. Die Photovoltaikdachpfanne 1 weist zunächst ein unten dargestelltes Grundgerüst auf. So umfasst die Photovoltaikdachpfanne 1 eine Unterseite 2 (angedeutet durch den Pfeil), die im Wesentlichen durch das Bodenblech 3 ausgebildet ist. Die Unterseite 2 dient der zumindest bereichsweisen Auflage der Photovoltaikdachpfanne 1 auf einer nicht dargestellten Dachkonstruktion. Ferner weist die Photovoltaikdachpfanne 1 eine Frontseite 4, zwei gegenüberliegende Seitenwände 5 und 6, sowie eine der Frontseite 4 gegenüberliegende Rückseite 7 auf. Die Frontseite 4 und die Rückseite 7 verbinden die zwei Seitenwände 5, 6 miteinander.

Des Weiteren weist die Photovoltaikdachpfanne 1 eine Oberseite 8 auf, die im Wesentlichen aus dem Glaspaket 9 gebildet ist. Teil dieses Glaspakets 9 ist unter anderem ein Photovoltaikmodul, das auf bekannte Art und Weise elektrische Energie aus Sonnenstrahlung generiert. Die Oberseite 8 und die Unterseite 2 verbinden gemeinsam die zwei Seitenwände 5, 6, die Rückseite 7 und die Frontseite 4 miteinander, sodass in der Photovoltaikdachpfanne 1 ein Hohlraum 10 ausgebildet ist.

Die Oberseite 8 der Photovoltaikdachpfanne 1 ist nicht gänzlich durch das Glaspaket 8 verschlossen. Wie Figur 2, die die Photovoltaikdachpfanne 1 aus Figur 1 in einem zusammengebauten Zustand in einer Draufsicht zeigt, veranschaulicht, weist die Oberseite 8 im Bereich der Rückseite 7 eine Ausströmöffnung 11 auf. Durch diese Ausströmöffnung 11 ist der Hohlraum 10 der Photovoltaikdachpfanne 1 somit von außen zugänglich.

Das Glaspaket 9 stellt eine Abdeckung für die Photovoltaikdachpfanne 1 dar. Diese Abdeckung verschließt den Hohlraum 10 auf der Oberseite 8 der Photovoltaikdachpfanne 1 teilweise. Durch den nicht durch das Glaspaket 9 verschlossenen Teil ist die Ausströmöffnung 11 ausgebildet.

Die Lage der Ausströmöffnung 11 in der Oberseite 8 ist dadurch veränderlich, dass die Abdeckung bzw. das Glaspaket 9 entlang einer von der Frontseite 4 bis zur Rückseite 7 verlaufenden Längsrichtung L verschiebbar ausgebildet ist. Aus dem in Figur 2 zu erkennenden Zustand kann das Glaspaket 9 etwa in Längsrichtung L verschoben werden, sodass die Ausströmöffnung 11 verkleinert wird. Gleichzeitig wird dadurch jedoch ein weiterer Zugang in den Hohlraum 10 der Photovoltaikdachpfanne 1 freigelegt. So wird durch das Verschieben des Glaspaketes 9 auf der Oberseite 8 der Photovoltaikdachpfanne 1 der Hohlraum 10 auch nahe der Frontseite 4 von außen zugänglich gemacht. Die Verschiebbarkeit der Abdeckung bzw. des Glaspaketes 9 erleichtert somit Montage- oder Wartungsarbeiten, denn der Hohlraum 10 der Photovoltaikdachpfanne 1 kann auf diese Weise an verschiedenen Stellen bedarfsabhängig von außen zugänglich gemacht werden.

Wie anhand von Figur 1 zu erkennen ist, weist die Unterseite 2 auch eine Öffnung in Form der Einströmöffnung 12 auf. Auch über diese Einströmöffnung 12 ist der Hohlraum 10 der Photovoltaikdachpfanne 1 von außen zugänglich.

Wesentlich für die vorliegende Erfindung ist nun die Erkenntnis, dass der Hohlraum 10 der Photovoltaikdachpfanne 1 dadurch genutzt werden kann, dass er durch die erwähnten Öffnungen Einströmöffnung 12 und Ausströmöffnung 11 von außen zugänglich gemacht wird. So dient die Einströmöffnung 12 dafür, dass aus einer Umgebung U anströmende Umgebungsluft in den Hohlraum 10 der Photovoltaikdachpfanne 1 eindringen kann. Dort strömt diese Umgebungsluft dann in Richtung der Ausströmöffnung 11 der Photovoltaikdachpfanne 1. Auf diesem Strömungsweg passiert die Umgebungsluft unter anderem das Glaspaket 9 bzw. das Photovoltaikmodul, welches sich im Betrieb stark erhitzt. Diese Erhitzung wird energetisch genutzt, indem die entstehende Abwärme an die den Hohlraum 10 der Photovoltaikdachpfanne 1 durchströmende Umgebungsluft abgegeben wird. Die auf diese Weise erwärmte Umgebungsluft kann beispielsweise in Photovoltaikdachpfannen 1 nachgeschalteten Wärmepumpen oder anderen Verbrauchern technisch genutzt werden.

Zu diesem Zweck können mehrere Photovoltaikdachpfannen 1 in Reihe miteinander verbunden werden, auf einer Dachkonstruktion gesehen von unten nach oben, sodass die Ausströmöffnung 11 einer unteren Photovoltaikdachpfanne 1 immer in Übereinstimmung mit der Einströmöffnung 12 einer darüber angeordneten, benachbarten Photovoltaikdachpfanne 1 gebracht ist. Auch seitlich benachbart können mehrere Photovoltaikdachpfannen 1 auf einem Dach vorgesehen sein. Dazu können seitlich benachbarte Photovoltaikdachpfannen 1 über den an der Seitenwand 5 vorgesehenen Auflageabschnitt 13 und den an der Seitenwand 6 vorgesehenen Klemmabschnitt 14 zumindest formschlüssig miteinander verbunden werden. Auch mit handelsüblichen Dachpfannen können die Photovoltaikdachpfannen 1 seitlich miteinander verbunden werden. Dazu müssen die handelsüblichen Dachpfannen ebenfalls lediglich die passenden Gegenstücke in Form eines Auflageabschnittes 13 und eines Klemmabschnittes 14 aufweisen. Aus diesem Zweck weist die erfindungsgemäße Photovoltaikdachpfanne 1 auch Abmessungen sowie eine äußere Form auf, die im Wesentlichen der Form und Abmessungen einer herkömmlichen Dachpfanne entsprechen.

Nicht dargestellt im vorliegenden Ausführungsbeispiel sind elektrische Verbindungselemente, beispielsweise in Form eines Steckers sowie einer Buchse, über die die benachbarten Photovoltaikdachpfanne 1 untereinander elektrisch leitend verbunden werden können.

Zur Verbindung bzw. zur Sicherung mehrerer auf einem Dach angeordneter Photovoltaikdachpfannen 1 ist eine sogenannte Sturmsogsicherung 15 vorgesehen. Der nachfolgend dargestellten und erläuterten Sturmsogsicherung 15 kommt eine eigene erfinderische Bedeutung zu. Diese Sturmsogsicherung 15 kann unter bestimmten Voraussetzungen auch bei handelsüblichen Dachpfannen eingesetzt werden.

Im vorliegend dargestellten und insofern bevorzugten Ausführungsbeispiel weist die Photovoltaikdachpfanne 1 die Sturmsogsicherung 15 auf. Diese Sturmsogsicherung 15 erstreckt sich im zusammengebauten Zustand durch den Hohlraum 10 von der Rückseite 7 in Richtung der Frontseite 4 bis wenigstens in den Bereich der Einströmöffnung 12.

Die Sturmsogsicherung 15 weist eine sich entlang der Längsrichtung L erstreckende Welle 16 auf. Um diese Welle 16 herum ist eine Druckfeder 17 angeordnet. Auf dem der Frontseite 4 zugewandten Ende der Welle 16 ist ein Hakenelement 18 der Sturmsogsicherung 15 angeordnet.

Das Hakenelement 18 ist entlang der Welle 16 längsverschiebbar ausgebildet. Das Hakenelement 18 kann entlang der Längsrichtung L auf der Welle 16 zurück verschoben werden, wodurch die Druckfeder 17 komprimiert wird. In ihrem Grundzustand jedoch ist das Hakenelement 18 durch die Druckfeder 17 in der dargestellten, in Richtung der Frontseite 4 verschobenen Position gehalten.

An dem Hakenelement 18 ist eine Einführspitze 19 vorgesehen. Bei dieser Einführspitze 19 handelt es sich vorliegend um einen Nagel. Es kann sich aber auch um einen Stift, ein Bolzenelement, einen Dorn oder dergleichen handelt. Die Einführspitze kann in eine korrespondierende Aufnahmeöffnung einer anderen, beispielsweise benachbarten Sturmsogsicherung eingeführt werden (später anhand der Aufnahmeöffnung 30 näher erläutert). Dadurch, dass mehrere Sturmsogsicherungen von mehreren, benachbarten Photovoltaikdachpfannen 1 miteinander verbunden, und zwar auf einfache Weise ineinandergesteckt, werden können, können die benachbarten Photovoltaikdachpfannen 1 auf einfache Weise auch untereinander verbunden und somit gesichert werden.

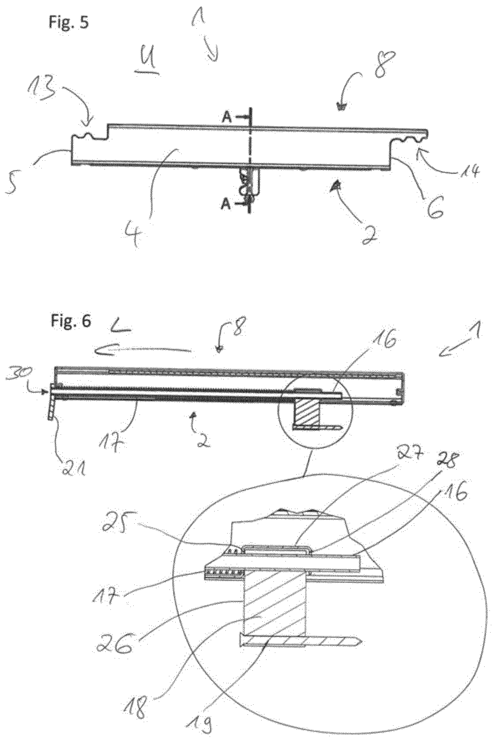

Dadurch, dass vorliegend die Einführspitze 19 der beschriebenen Sturmsogsicherung 15 als Nagel ausgebildet ist, welcher, wie Figur 6 zu entnehmen ist, durch eine Durchgangsbohrung durch einen Grundkörper des Hakenelementes 18 geführt ist, ist die Montage der Sturmsogsicherung 15 bzw. der entsprechenden Dachpfannen 1 vereinfacht. Denn der Nagel bzw. die Einführspitze 19 kann bei Bedarf auch erst vor Ort durch die Durchgangsbohrung geführt werden, um den Formschluss der benachbarten Sturmsogsicherungen 15 und somit der benachbarten Dachpfannen 1 herzustellen.

Im zusammengebauten Zustand ist die Sturmsogsicherung 15 an der Rückseite 7 der Photovoltaikdachpfanne 1 festgelegt. Dazu weist die Rückseite 7 eine Bohrung 20 auf, durch welche die Welle 16 der Sturmsogsicherung 15 geführt ist. Ferner weist die Sturmsogsicherung 15 auch eine Sicherungsplatte 21 auf, über welche die Sturmsogsicherung 15 und letztlich somit auch die Photovoltaikdachpfanne 1 an einer Dachlatte einer Dachkonstruktion festgelegt werden kann. Dazu wird die Photovoltaikdachpfanne 1 über einen Nagel oder, wie beispielhaft in den Figuren 2, 3 und 4 zu erkennen, über eine Schraube 22 mittels der Sicherungsplatte 21 sicher mit der Dachlatte verbunden.

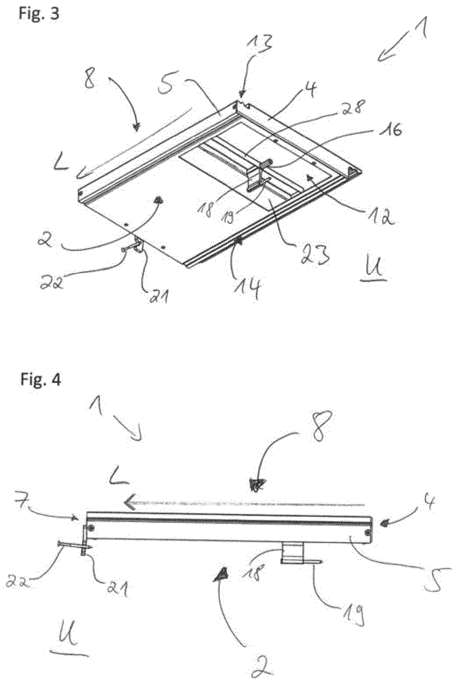

Die Photovoltaikdachpfanne 1 weist zusätzlich noch einen Luftschieber 23 auf. Der Luftschieber 23 kann die Einströmöffnung 12 bei Bedarf zumindest teilweise verschließen, wie in Figur 3, die die Photovoltaikdachpfanne 1 in einer perspektivischen Ansicht von unten zeigt, zu erkennen ist. Der Luftschieber 23 kann entlang der Längsrichtung L verschoben werden und somit die Einströmöffnung 12 vergrößern bzw. verkleinern. Der Luftschieber 23 ist dazu in seiner Gesamtheit verschiebbar ausgebildet. Der Luftschieber 23 kann auch so weit entlang der Längsrichtung L zurück verschoben sein, dass die Einströmöffnung 12 gar nicht, also auch nicht teilweise, durch den Luftschieber 23 verschlossen ist. Dann ist der Luftschieber 23 komplett oberhalb des Bodenblechs 3 und ragt entgegen der Längsrichtung L gesehen nicht bis über die Einströmöffnung 12 hervor.

Die Längsbewegung des Luftschiebers 23 ist dabei mit der Bewegung der Sturmsogsicherung 15 bzw. des Hakenelementes 18 gekoppelt. So weist der Luftschieber 23 zunächst einen Basisabschnitt 24 auf. Der Basisabschnitt 24 verläuft im Wesentlichen parallel zur Unterseite 2 bzw. zum Bodenblech 3. Der Basisabschnitt 24 kann zur Längsverschiebung entlang des Bodenbleches 3 entlang gleiten.

Der Luftschieber 23 weist ferner einen von dem Basisabschnitt 24 im Wesentlichen senkrecht nach oben in Richtung Oberseite 8 erstreckenden Ansatzabschnitt 25 auf. An einer der Frontseite 4 zugewandten Seite des Ansatzabschnittes 25 liegt eine der Rückseite 7 zugewandte Seite 26 des Hakenelementes 18 an, wie anhand der vergrößerten Darstellung eines Details in Figur 6 zu erkennen ist. Auf diese Weise sorgt eine Verschiebung des Hakenelementes 18 auch gleichzeitig automatisch für eine Verschiebung des Luftbleches 23, indem das Hakenelement 18 gegen des Ansatzabschnitt 25 des Luftbleches 23 drückt.

Der Ansatzabschnitt 25 weist ferner eine Durchgangsöffnung auf, durch den sich die Welle 16 der Sturmsogsicherung 15 erstreckt.

An den Ansatzabschnitt 25 anschließend weist der Luftschieber 23 einen Dachabschnitt 27 auf. Der Dachabschnitt 27 verläuft im Wesentlichen senkrecht zum Ansatzabschnitt 25 und im Wesentlichen parallel zum Basisabschnitt 24. An den Dachabschnitt 27 wiederum schließt ein im Wesentlichen senkrecht zum Dachabschnitt 27 verlaufender und sich erneut nach unten Richtung Unterseite 2 erstreckender Sicherungsabschnitt 28 an. In diesem Sicherungsabschnitt 28 ist ebenfalls eine Durchgangsöffnung 29, nämlich eine der Frontseite 4 zugewandte Durchgangsöffnung 29 vorgesehen, durch die ebenfalls die Welle 16 der Sturmsogsicherung 15 geführt ist.

An ihrem gegenüberliegenden Ende ist die Welle 15 an der Rückseite 7 der Photovoltaikdachpfanne 1 festgelegt. Wie der Detailvergrößerung in Figur 6 zu entnehmen ist, sorgt eine Längsverschiebung des Hakenelementes 18 für keine Lageänderung der Welle 16 der Sturmsogsicherung 15. Vielmehr kann das Hakenelement entlang der Welle 15 verschoben werden, wodurch der Ansatzabschnitt 25 des Luftschiebers 23 ebenfalls verschoben wird und gleichzeitig die Druckfeder 17 komprimiert wird. Auf diese Weise wird die Montage der Photovoltaikdachpfannen 1 erleichtert.

So wird ein Dach regelmäßig derart eingedeckt, dass zuerst eine im Montagezustand unten liegende Photovoltaikdachpfanne 1 auf der Dachkonstruktion festgelegt wird, beispielsweise mittels eines Nagels oder, wie vorliegend dargestellt, der Schraube 22 in einer Dachlatte gesichert wird. Die Photovoltaikdachpfanne 1 könnte alternativ auch nur von oben mit der Sicherungsplatte 21 an einer Dachlatte eingehakt werden, ohne zusätzlich mit der Schraube 22 in dieser festgeschraubt zu werden.

Daraufhin wird eine weitere Photovoltaikdachpfanne 1 oberhalb der vorherigen angebracht. Die Verbindung kann dann vorteilhaft zwischen beiden Photovoltaikdachpfannen 1 hergestellt werden, indem das Hakenelement 18 der Sturmsogsicherung 15 der oberen Photovoltaikdachpfanne 1 mit einer Aufnahmeöffnung 30 der Sturmsogsicherung 15 der unteren Photovoltaikdachpfanne 1 in Eingriff gebracht wird.

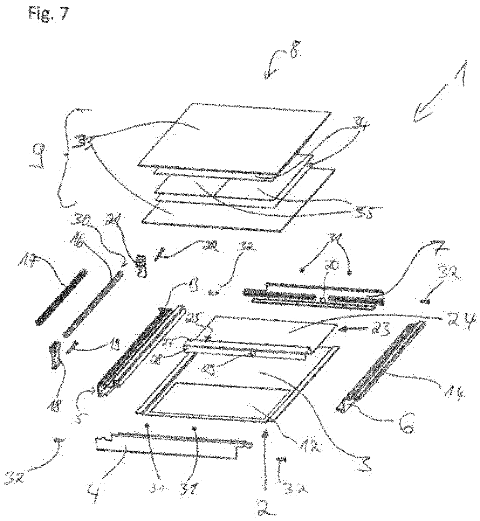

Die Aufnahmeöffnung 30 korrespondiert also zu der Einführspitze 19 einer Sturmsogsicherung 15. Die Aufnahmeöffnung 30 ist in den Figuren 1 und 7 angedeutet und insbesondere Figur 6 zu entnehmen. Die Aufnahmeöffnung 30 ist dabei dadurch ausgebildet, dass als Welle 16 eine Hohlwelle verwendet wird. Die zentrale Öffnung dieser Hohlwelle an dem der Rückseite 7 zugeordneten Ende der Welle 16 dient also als Aufnahmeöffnung 30 für die Einführspitze 19 einer benachbarten Sturmsogsicherung 15.

Diese Montageabreiten sowie ebenso das Herstellen der angesprochenen elektrischen Verbindungen können in vorteilhafter Weise auf einfach handzuhabende Weise auch über die Ausströmöffnung 11 der oberen Photovoltaikdachpfanne 1 durchgeführt werden.

Die Druckfeder 17 hält das Hakenelement 19 in ihrer in Richtung Frontseite 4 verschobenen Position und sorgt somit gleichzeitig dafür, dass die Einführspitze 19 einer im eingedeckten Dach oberhalb angeordneten Photovoltaikdachpfanne 1 in die Aufnahmeöffnung 30 einer unterhalb angeordneten Photovoltaikdachpfanne 1 gehalten wird.

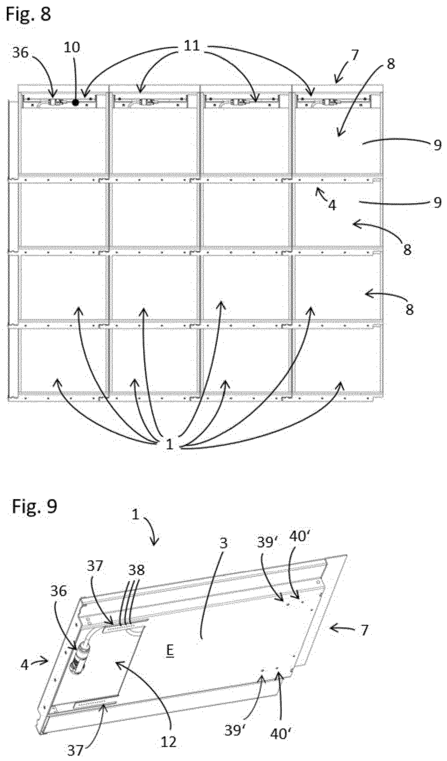

Die beschriebene Sturmsogsicherung 15 kann zur Unterscheidung zu der später im Rahmen des Ausführungsbeispiels ab Figur 8 beschriebenen, alternativen Sturmsogsicherung auch als die eine Welle 16 aufweisende Sturmsogsicherung 15 bezeichnet werden.

Figur 7 zeigt die Photovoltaikdachpfanne 1 in einer nochmals weiter auseinander gezogenen Explosivdarstellung. Dabei sind einzelne Niete 31 sowie Schrauben 32 zu erkennen, die der Verbindung der Seitenwände 5, 6, der Frontseite 4, der Rückseite 7 und des Bodenblechs 3 dienen. Ferner ist das im Wesentlichen die Oberseite 8 ausbildende Glaspaket 9 in seinen Einzelteilen dargestellt. Das Glaspaket 9 weist dabei eine obere und eine untere Glasplatte 33 auf, zwischen denen eine obere und eine untere Ethylen-Vinylacetat-Folie 34 angeordnet ist. In diese beiden Ethylen-Vinylacetat-Folien 34 sind zwei nebeneinanderliegende Solarzellen 35, im Wesentlichen aus Siliziumnitrid gebildet, angeordnet. Dadurch ist das Photovoltaikmodul ausgebildet, welches vorliegend der Gewinnung elektrischer Energie aus Sonnenstrahlung dient.

Das Glaspaket 9 erhitzt sich bedingt durch die Sonnenstrahlung und durch den Betrieb stark. Dabei entsteht Abwärme, die durch die vorliegende Photovoltaikdachpfanne 1 gezielt genutzt wird. So wird durch die Einströmöffnung 12 Umgebungsluft aus der Umgebung U angesaugt, welche durch den Hohlraum 10 der Photovoltaikdachpfanne 1 strömt und aus der Ausströmöffnung 11 wieder austritt, und zwar als aufgewärmte Luft. Diese aufgewärmte Luft kann dann gezielt in Verbrauchern wie Wärmepumpen und dergleichen eingesetzt werden.

Damit die sich erwärmende, den Hohlraum 10 der Photovoltaikdachpfanne 1 durchströmende Luft nicht ungenutzt aus der Photovoltaikdachpfanne 1 austritt, sind die Bauteile Unterseite 2 bzw. Bodenblech 3, Seitenwände 5, 6, Frontseite 4, Rückseite 7 sowie Oberseite 8 bzw. Glaspaket 9 luftdicht miteinander verbunden bzw. abgedichtet.

In Figur 8 ist beispielhaft ein Auszug eines mit Photovoltaikdachpfannen 1 einggedeckten Daches zu erkennen. Dabei sind vier Reihen mit jeweils vier übereinander angeordneten Photovoltaikdachpfannen 1 dargestellt, wobei lediglich die unteren beiden Reihen an Photovoltaikdachpfannen 1 mit dem Bezugszeichen 1 gekennzeichnet sind. In der dargestellten Draufsicht von oben auf die Oberseiten 8 der Photovoltaikdachpfannen 1 sind jeweils die Glaspakete 9 der Photovoltaikdachpfannen 1 zu erkennen. Weiterhin sind anhand der obersten Reihe an Photovoltaikdachpfannen 1 die Ausströmöffnungen 11 zu erkennen. Über diese Ausströmöffnungen 11 ist der Zugriff in den Hohlraum 10 der Photovoltaikdachpfannen 1 gewährleistet.

Der Zugriff in den Hohlraum 10 einer Photovoltaikdachpfanne 1 bringt vor allem den Vorteil, dass nach der prinzipiellen Dacheindeckung weitere Montage- bzw. Instandhaltungsmaßnahmen einfach möglich sind. So kann das Dach auch zunächst grundsätzlich durch einen Dachdecker eingedeckt werden. Die vorschlagsgemäßen Photovoltaikdachpfannen 1 lassen sich auf dem Dach wie eine normale Dachpfanne verlegen. Diese Tätigkeit kann durch einen Dachdecker ohne eine besondere Zusatzausbildung erfolgen. Sodann kann die elektrische Verbindung benachbarter Photovoltaikdachpfannen 1, bzw. generell Instandhaltungsmaßnahmen insbesondere auf die elektrischen Komponenten bezogen, durch dafür extra ausgebildetes Personal durchgeführt werden. Die Photovoltaikdachpfannen 1 können somit nachträglich zur Eindeckung durch einen Dachdecker z.B. von einem Solarteur oder einem Dachdecker mit Zusatzausbildung festgeschraubt und angeschlossen werden, wozu insbesondere die Verschieblichkeit der Abdeckung bzw. hier des Glaspakets 9 der jeweiligen Photovoltaikdachpfanne 1 vorteilhaft ist.

Der Zugriff in den Hohlraum 10 einer Photovoltaikdachpfanne 1 ist vor allem dadurch permanent gewährleistet, dass sowohl die Unterseite 2 eine untere Öffnung in Form der Einströmöffnung 12 als auch die Oberseite 8 eine obere Öffnung in Form der Ausströmöffnung 11 aufweist. Ganz besonders vorteilhaft ist, dass die Oberseite 8 eine in Längsrichtung verschiebbar ausgebildete Abdeckung aufweist. Vorliegend ist diese Abdeckung durch das Glaspaket 9 selbst gebildet.

Wie anhand der obersten Reihe an Photovoltaikdachpfannen 1 zu erkennen ist, sind in dem Hohlraum 10 der Photovoltaikdachpfannen 1 die elektrischen Komponenten 36 der Photovoltaikdachpfannen 1 vorgesehen. Bei einem bereits eingedeckten Dach können die elektrischen Komponenten 36 benachbarter der Photovoltaikdachpfannen 1 in vorteilhafter Weise ganz einfach bestimmungsgemäß mit den benachbarten elektrischen Komponenten 36 benachbarter Photovoltaikdachpfannen 1 verbunden werden. Der Zugriff in den Hohlraum 10 ist dadurch besonders variabel, dass das Glaspaket 9 einfach nach oben verschoben werden kann und daraufhin die eigentlich oberhalb nahe der Rückseite 7 der Photovoltaikdachpfanne 1 angeordnete Ausströmöffnung 11 nun weiter unten nahe der Frontseite 4 eine weitere obere Öffnung zum Hohlraum 10 bereitstellt und somit einen Zugriff in den Hohlraum 10 der Photovoltaikdachpfanne 1 auch nahe der Frontseite 4 erlaubt. Hierüber kann sodann auch direkt der Zugriff in die darunter liegende Photovoltaikdachpfanne 1, konkret über die Ausströmöffnung 11 dieser unterhalb benachbarten Photovoltaikdachpfanne 1, erfolgen.

Figur 9 zeigt ein weiteres Ausführungsbeispiel einer Photovoltaikdachpfanne 1, die in Figur 9 jedoch nur teilweise dargestellt ist. Dabei ist in Figur 9 insbesondere das Bodenblech 3 zu erkennen. Eine solche Photovoltaikdachpfanne 1 bzw. eine Photovoltaikdachpfanne 1 mit einem solchen Bodenblech 3 kann bei der Eindeckung des Dachs, wie zuvor am Beispiel der Figur 8 beschrieben, verwendet werden.

Im Unterschied zum zuvor dargestellten Ausführungsbeispiel weist das Bodenblech 3 in dem hier dargestellten Grundzustand der Photovoltaikdachpfanne 1, welcher vor der Montage auf einem Dach vorliegt, zwei in sich in Richtung der Frontseite 4 der Photovoltaikdachpfanne 1 erstreckende, in dem Bereich der Einströmöffnung 12 angeordnete Blechlaschen 37 auf. Diese Blechlaschen 37 erstrecken sich im in Figur 9 dargestellten Grundzustand der Photovoltaikdachpfanne 1 im Wesentlichen parallel zur Grundebene E des Bodenblechs 3. Die zwei Blechlaschen 37 sind wiederum auch parallel zueinander angeordnet. Ferner weisen die Blechlaschen 37 mehrere, in regelmäßigen Abständen zueinander angeordnete Bohrungen 38 auf, welche nur teilweise in Figur 9 mit dem Bezugszeichen 38 gekennzeichnet sind. Konkret weist in dem dargestellten Ausführungsbeispiel jede Blechlasche 37 zwölf Bohrungen 38 auf.

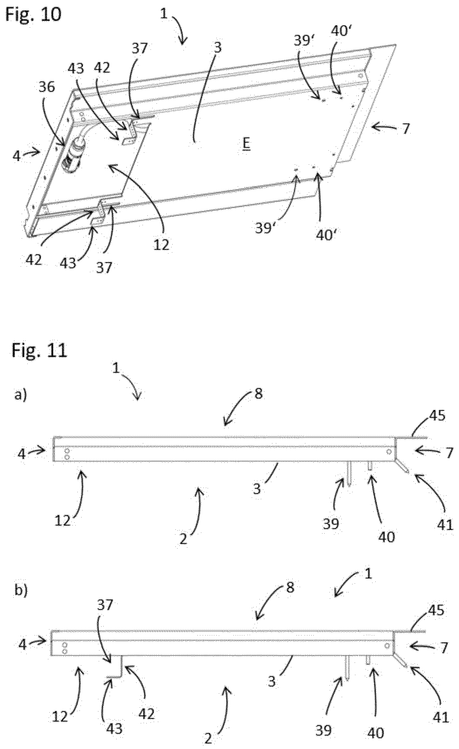

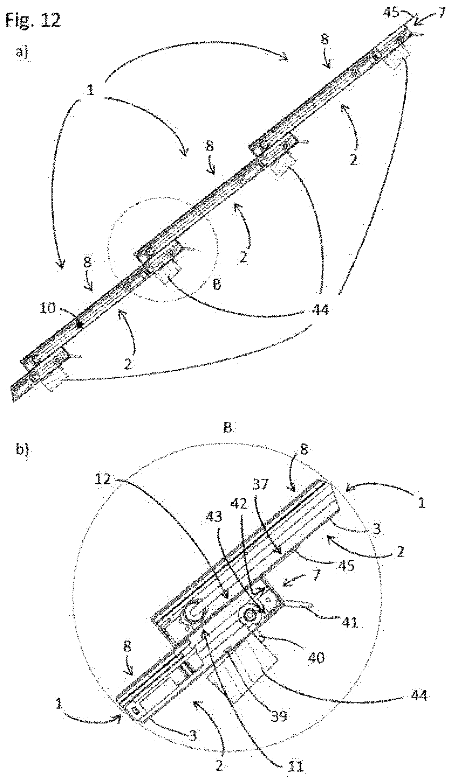

Ferner sind in dem Bereich der Rückseite 7 der Photovoltaikdachpfanne 1 weitere Bohrungen vorgesehen, die insbesondere für die später dargestellten Komponenten für die Montage auf dem Dach notwendig sind. In Figur 9 sowie ebenfalls in Figur 10 sind jeweils zwei Sturmsogsicherungsbohrungen 39', sowie jeweils zwei Lattenhalterungsbohrungen 40' vorgesehen. Diese sind für die später in den Figuren 11 und 12 zu erkennenden Komponenten in Form der bodenblechseitigen Sturmsogsicherungselemente 39, sowie weiterhin der Lattenhalterungen 40 vorgesehen. Die Funktionalität dieser Komponenten, sowie ferner der ebenfalls in Figuren 11 und 12 zu erkennenden Potentialausgleichelemente 41 wird insbesondere im Rahmen der in dem montierten Zustand auf einem Dach dargestellten der Photovoltaikdachpfannen 1 im Rahmen der Figur 12 beschrieben.

Bei dem dargestellten und nachfolgend weiterhin beschriebenen Ausführungsbeispiel kann, wie dargestellt, bedarfsweise auch auf die im Rahmen der zuvor in den Figuren 1 bis 7 beschriebenen Photovoltaikdachpfanne 1 eingesetzten Komponenten in Form der die Welle 16 aufweisenden Sturmsogsicherung 15 und auch des Luftschiebers 23 verzichtet werden.

Figur 10 zeigt das Ausführungsbeispiel gemäß Figur 9, nun jedoch in einem Montagezustand dargestellt, sprich in einem Zustand wie die Photovoltaikdachpfanne 1 auf einem Dach montiert wird. Im Unterschied zu Figur 9 sind nun die beiden Blechlachsen 37 an die in Figur 10 nicht dargestellte unterhalb der Photovoltaikdachpfanne 1 angeordnete, benachbarte weitere Photovoltaikdachpfanne angepasst ausgebildet. Dazu ist die jeweilige Blechlasche 37 im Vergleich zu dem Grundzustand gemäß Figur 9 ein erstes Mal um im Wesentlichen 90° nach unten umgebogen, sowie danach ein weiteres Mal um im Wesentlichen 90° wieder erneut nach oben umgebogen. Dementsprechend weisen die Blechlaschen 37 jeweils einen im Montagezustand im Wesentlichen senkrecht zur Grundebene E des Bodenblechs 3 bzw. senkrecht zum Dach verlaufenden Vertikalabschnitt 42, sowie an diesen Vertikalabschnitt 42 anschließend einen im Montagezustand im Wesentlichen parallel zur Grundebene E des Bodenblechs 3 bzw. parallel zum Dach verlaufenden Horizontalabschnitt 43 auf.

Figur 11 zeigt Seitenansichten der Darstellungen der Photovoltaikdachpfannen 1 aus Fig. 9 (in der Ansicht a) der Fig. 11), sowie aus Fig. 10 (in der Ansicht b) der Fig. 11). Zusätzlich zu den Darstellungen der Figuren 9 und 10 sind nun jedoch auch die Elemente bodenblechseitiges Sturmsogsicherungselement 39, Lattenhalterung 40, sowie Potentialausgleichelement 41 zu erkennen. Es wird deutlich, dass das bodenblechseitige Sturmsogsicherungselement 39 sich von dem Bodenblech 3 aus im Wesentlichen senkrecht nach unten erstreckt. Ebenso erstreckt sich die Lattenhalterung 40 von dem Bodenblech 3 aus im Wesentlichen senkrecht nach unten. Schließlich ist das Potentialausgleichelement 41 in einer Ecke in einem Übergangsbereich zwischen dem Bodenblech 3 und der Rückseite 7 angeordnet und erstreckt sich schräg nach unten und hinten bezogen auf die dargestellte Ansicht der Photovoltaikdachpfanne 1.

Bei den Komponenten bodenblechseitiges Sturmsogsicherungselement 39, Lattenhalterung 40, sowie Potentialausgleichelement 41 kann es sich vorzugsweise um lose, separate bzw. getrennt von dem Bodenblech 3 bzw. der Photovoltaikdachpfanne 1 vorgesehene Komponenten handeln. So kann es sich bei dem bodenblechseitigen Sturmsogsicherungselement 39 um einen Nagel oder auch eine Schraube handeln, mittels der die Photovoltaikdachpfanne 1 über das Bodenblech 3 durch die Bohrung 39' an einer in Figur 11 nicht dargestellten Dachlatte montiert werden kann. Bei der Lattenhalterung 40 kann es sich beispielsweise um einen, vorzugsweise metallischen, Stift handeln oder ebenfalls um eine Schraube, welcher Stift bzw. welche Schraube durch die Bohrung 40' in dem Bodenblech 3 eingesetzt werden und zur Sicherung als Anschlag von oben gegen eine in Figur 11 nicht dargestellten Dachlatte dienen kann. Das Potentialausgleichelement 41 kann ebenfalls als Nagel oder auch Schraube ausgebildet sein. Das Potentialausgleichelement 41 kann sich sowohl durch das Bodenblech 3 bzw. den Übergang zwischen Bodenblech 3 und Rückseite 7 einer Photovoltaikdachpfanne 1 als auch gleichzeitig durch eine Blechlasche 37 einer benachbarten, oberhalb angeordneten Photovoltaikdachpfanne erstrecken. Dieses Potentialausgleichelement 41 dient sodann auch teilweise zur Verbindung zweier zueinander (oberhalb und unterhalb) benachbarter Photovoltaikdachpfannen 1 und trägt somit auch teilweise zur Sturmsogsicherung bei. Das Potentialausgleichelement 41 kann bei der Montage und Verbindung zweier benachbarter Photovoltaikdachpfannen 1 miteinander durch eine Bohrung 38 der Blechlasche 37 eingeführt werden und sodann diese Blechlasche 37 der oberen benachbarten Photovoltaikdachpfanne 1 mit dem Bodenblech 3 der darunter benachbarten Photovoltaikdachpfanne 1 verbinden.

Die drei Komponenten bodenblechseitiges Sturmsogsicherungselement 39, Lattenhalterung 40, sowie Potentialausgleichelement 41 sind auch in Figur 12 im Detail und im Einsatz, sprich in einem Montagezustand der dargestellten Photovoltaikdachpfannen 1 auf einem Dach, zu erkennen. Dabei sind die in der Ansicht a) drei Photovoltaikdachpfannen 1 vollständig und eine weitere Photovoltaikdachpfanne 1 am unteren, linken Rand teilweise dargestellt zu erkennen, wobei diese Photovoltaikdachpfannen 1 auf einem Dach, welches durch die vier Dachlatten 44 angedeutet ist, montiert sind.

Zur Montage wird das Dach auf übliche Weise durch einen Dachdecker mit den Photovoltaikdachpfannen 1 eingedeckt. Dazu ist besonders vorteilhaft, dass die jeweilige Photovoltaikdachpfanne 1 zunächst auf eine Dachlatte 44 gelegt und mittels einer Lattenhalterung 40 an dieser Dachlatte 44 von oben angelegt werden kann. So kann das Dach mit den vorschlagsgemäßen Photovoltaikdachpfannen 1 prinzipiell wie mit üblichen, normalen Dachpfannen eingedeckt werden. Von besonderem Vorteil ist dabei, dass der Dachdecker jederzeit von oben in den Hohlraum 10 der Photovoltaikdachpfanne 1 zugreifen kann. Dies ist auf die bereits beschriebene Weise dadurch gewährleistet, dass auf der Oberseite 8 der Photovoltaikdachpfannen 1 jeweils obere Öffnungen in Form der Ausströmöffnungen 11 vorgesehen sind, und ferner dadurch erleichtert, dass die Abdeckung bzw. das Glaspaket oben verschiebbar ausgebildet sind. So ist auch über diesen Zugriff in den Hohlraum 10 gewährleistet, dass der Monteur die Photovoltaikdachpfanne 1 dadurch auf einfache Weise auf dem Dach sichern kann, dass die Photovoltaikdachpfanne 1 über das Bodenblech 3 und die eingebrachten bodenblechseitigen Sturmsogsicherungselemente 39 mit der jeweiligen Dachlatte 44, etwas mittels Vernageln oder Verschrauben, verbunden werden kann.

Schließlich können dann benachbarte Photovoltaikdachpfannen 1 vorgesehen werden, indem jeweils die obere Photovoltaikdachpfanne 1 auf die unterhalb benachbarte Photovoltaikdachpfanne 1 aufgelegt wird und derart mit dieser unterhalb angeordneten Photovoltaikdachpfanne 1 in Übereinstimmung gebracht wird, dass die Einströmöffnung 12 (untere Öffnung) der oberen Photovoltaikdachpfanne 1 mit der Ausströmöffnung 11 (obere Öffnung) der unteren Photovoltaikdachpfanne 1 zumindest teilweise in Übereinstimmung ist.

Die Blechlaschen 37 der oberhalb benachbarten Photovoltaikdachpfanne 1 können dazu umgebogen und angepasst werden, sodass der jeweilige Vertikalabschnitt 42 der Blechlasche 37 innen an der Rückseite 7 der unterhalb angeordneten Photovoltaikdachpfanne 1 anliegt, sowie sodass der Horizontalabschnitt 43 der Blechlasche 37 innen auf dem Bodenblech 3 der unterhalb angeordneten Photovoltaikdachpfanne 1 aufliegt. Sodann können Bodenblech 3 bzw. Rückseite 7 der unterhalb angeordneten Photovoltaikdachpfanne 1 mit der Blechlasche 37 miteinander verbunden werden, indem das Potentialausgleichelement 41 durch diese beiden Komponenten durchgeschlagen bzw. festgeschraubt wird. Dazu ist besonders vorteilhaft, dass in der Blechlasche 37 verschiedene, in regelmäßigen Abständen angeordnete Bohrungen 38 vorgesehen sind, durch welche Bohrungen 38 dann das Potentialausgleichelement 41 eingebracht werden kann. Auf diese Weise kann auch besonders vorteilhaft darauf reagiert werden, dass Dachlatten 44 auf einem Dach nicht immer gleichmäßig beabstandet sind und daher auch die Abstände zwischen einzelnen Photovoltaikdachpfannen 1 immer um geringe Abstände variieren können. Die Blechlasche 37 kann hierbei vorteilhaft wie beschrieben erst beim Eindecken des Daches durch den Dachdecker aus dem Grundzustand derart umgebogen werden, dass die Horizontalabschnitte 43 und die Vertikalabschnitte 42 der Blechlaschen 37 perfekt zu der jeweils benachbarten Photovoltaikdachpfanne 1 passen.

Zur Unterstützung der Anordnung sowie ebenfalls der Verbindung benachbarter Photovoltaikdachpfannen 1 zueinander weisen die dargestellten Photovoltaikdachpfannen 1 auch jeweils einen Horizontalabschnitt 45 an der Rückseite 7 auf. Auf diesem Horizontalabschnitt 45 kann die nächste, oberhalb angeordnete Photovoltaikdachpfanne 1 immer mit ihrem Bodenblech 3 abgelegt werden. Außerdem dient dieser Horizontalabschnitt 45 in vorteilhafter Weise dazu, die Einströmöffnung 12 bzw. untere Öffnung einer oberhalb benachbarten Photovoltaikdachpfanne 1 teilweise von unten zu verdecken bzw. abzuschließen, falls sich diese Einströmöffnung 12 (untere Öffnung) der oberhalb angeordneten Photovoltaikdachpfanne 1 weiter über die eigentliche Seitenwand der Rückseite 7 der unterhalb angeordneten Photovoltaikdachpfanne 1 erstrecken sollte.

Das zuvor bereits teilweise beschriebene Potentialausgleichelement 41 dient auch dazu, dass die Gehäuse bzw. Grundkörper benachbarter Photovoltaikdachpfannen 1 miteinander elektrisch leitend verbunden werden können. So kann hierdurch ein Potentialausgleich geschaffen werden und elektrische Ströme, die beispielsweise aus einer Potentialdifferenz zwischen Oberseite und Unterseite der Photovoltaikdachpfannen 1 resultieren, gezielt abgeleitet und beispielsweise einer Erdung zugeführt werden. Hierzu können vorteilhaft sowohl die Bodenbleche 3 also auch die Blechlaschen 37 als auch die Potentialausgleichselemente 41 metallisch bzw. elektrisch leitend ausgebildet sein.

Durch die Anordnung von oberen Öffnungen in Form der Ausströmöffnungen 11 und von unteren Öffnungen in Form der Einströmöffnungen 12 werden unerwartete Vorteile hinsichtlich der Montage und vor allem auch der Einzel-Demontage von den vorschlagsgemäßen Solarenergiedachpfannen, wie der dargestellten Photovoltaikdachpfannen 1, erzielt. So kann bei einem eingedeckten Dach mit benachbarten Photovoltaikdachpfannen 1, die wie beschrieben beispielsweise über Potentialausgleichselemente 41 mit ihren Blechlaschen 37 und den Bodenblechen 3 der unterhalb benachbarten Photovoltaikdachpfannen 1 verbunden sind und ferner mittels Lattenhalterungen 40 an die Dachlatten 44 angelegt sowie mittels der bodenblechseitigen Sturmsogsicherungselemente 39 in den Dachlatten 44 gesichert sind, ganz einfach eine einzelne Photovoltaikdachpfanne 1 demontiert werden. Dazu kann beispielsweise bei der zu demontierenden Photovoltaikdachpfanne 1 die Abdeckung in Form der Oberseite 8 bzw. des Glaspakets 9 nach oben verschoben werden. In dieser nach oben verschobenen Position kann die Oberseite 8 beispielsweise auch durch Sicherungsmechanismen gesichert und in dieser Position gehalten werden. Sodann kann der Zugriff in den Hohlraum 10 dieser zu demontierenden Photovoltaikdachpfanne 1 erfolgen und weiterhin auch in den Hohlraum 10 der darunter liegenden Photovoltaikdachpfanne 1 zugegriffen werden, da deren obere Öffnung in Form der Ausströmöffnung 11 wiederum mit der unteren Öffnung der zu demontierenden Photovoltaikdachpfanne 1 in Form der Einströmöffnung 12 in Übereinstimmung angeordnet ist. Dort, in der unterhalb benachbarten Photovoltaikdachpfanne 1, kann sodann die Verbindung zwischen zu demontierender Photovoltaikdachpfanne 1 und der darunter liegenden Photovoltaikdachpfanne 1 durch Ausschrauben der diese beiden Photovoltaikdachpfannen 1 verbindenden Potentialausgleichselemente 41 gelöst werden. Dieser Vorgang kann sodann am oberen Ende nahe der Rückseite 7 der zu demontierenden Photovoltaikdachpfanne 1 wiederholt werden, diesmal jedoch, indem der Zugriff über die oberhalb der zu demontierenden Photovoltaikdachpfanne 1 benachbarte Photovoltaikdachpfanne 1 erfolgt. Denn dort bei der oberhalb benachbarten Photovoltaikdachpfanne 1 kann erneut die Oberseite 8 nach oben verschoben werden und daraufhin der Zugriff bis in den Hohlraum 10 der zu demontierenden Photovoltaikdachpfanne 1 erfolgen. Dort können dann alle notwendigen Verbindungen, konkret die eingeschraubten Potentialausgleichselemente 41, aber auch die Lattenhalterungen 40 sowie die bodenblechseitigen Sturmsogsicherungselemente 39 der zu demontierenden Photovoltaikdachpfanne 1, gelöst werden. Dann ist die zu demontierende Photovoltaikdachpfanne 1 nicht mehr gesichert und kann einfach nach unten aus dem Verbund mit den benachbarten Photovoltaikdachpfannen 1 herausgezogen werden. Eine erneute Montage einer Photovoltaikdachpfanne 1 in einen Verbund ist in umgekehrter Weise ebenso möglich.

Ergänzend zu der verschiebbar ausgebildeten Oberseite 8 können die beschriebenen Vorteile einer Einzeldemontage und auch Montage von Photovoltaikdachpfannen 1 ebenso durch eine schwenkbar ausgebildete Frontseite 4 erreicht werden. Durch ein Herunterklappen der Frontseite 4 kann nämlich analog zu einem zuvor beschriebenen Verschieben der Oberseite 8 nach oben ebenso der Zugriff in eine unterhalb benachbarte Photovoltaikdachpfanne 1, wiederum durch die in Übereinstimmung gebrachten Öffnungen in Form der Einströmöffnung 12 der oberen und der Ausströmöffnung 11 der unteren Photovoltaikdachpfanne 1 erfolgen.

Die beschriebenen Vorteile durch die Einströmöffnungen 12 und die Ausströmöffnungen 11 sind insbesondere hinsichtlich einer vereinfachten Montage und Demontage und Instandhaltungsmaßnahmen allgemein auf Solarenergiedachpfannen mit einer oberen Öffnung und einer unteren Öffnung wie beschrieben übertragbar. Die vorliegende Erfindung ist nicht beschränkt auf das beschriebene Ausführungsbeispiel einer Photovoltaikdachpfanne 1. Insbesondere können die Öffnungen auch nur ausschließlich zur Vereinfachung der Montage bzw. Verlegung der Solarenergiedachpfannen vorgesehen sein. Die Öffnungen sind auch dann vorteilhaft, wenn die Solarenergiedachpfannen nicht von einem Luftstrom durchströmt werden. Dies kann sowohl bei reinen Photovoltaikdachpfannen als auch bei Solarthermie- oder Kombinationsdachpfannen (Nutzung von Solarthermie und Photovoltaik) der Fall sein.

## Patentansprüche

1. Solarenergiedachpfanne, deren Form im Wesentlichen der Form einer herkömmlichen Dachpfanne entspricht und die mit einer benachbarten Solarenergiedachpfanne thermisch und/oder elektrisch leitend verbindbar ist, aufweisend:
- eine Unterseite (2) zur zumindest bereichsweisen Auflage auf einer Dachkonstruktion,
- eine der Unterseite (2) gegenüberliegende Oberseite (8), die zumindest bereichsweise durch ein Solarenergienutzungsmodul gebildet ist,
- zwei gegenüberliegende Seitenwände (5, 6),
- eine die zwei Seitenwände (5, 6) verbindende Rückseite (7), und
- eine der Rückseite (7) gegenüberliegende und ebenfalls die zwei Seitenwände (5, 6) verbindende Frontseite (4),
wobei die zwei Seitenwände (5, 6), die Rückseite (7) sowie die Frontseite (4) gemeinsam die Unterseite (2) und die Oberseite (8) verbinden, sodass ein Hohlraum (10) zwischen den zwei Seitenwänden (5, 6), der Rückseite (7), der Frontseite (4), der Unterseite (2) und der Oberseite (8) ausgebildet ist,
wobei die Unterseite (2) im Bereich der Frontseite (4) eine untere Öffnung zum Bereitstellen eines Zugriffs und die Oberseite (8) im Bereich der Rückseite (7) eine obere Öffnung zum Bereitstellen eines Zugriffs aus der Umgebung (U) in den Hohlraum (10) aufweist, **dadurch gekennzeichnet, dass** die Oberseite (8) eine in einer von der Frontseite (4) zu der Rückseite (7) verlaufenden Längsrichtung (L) verschiebbar ausgebildete Abdeckung aufweist.

2. Solarenergiedachpfanne nach Anspruch 1, **dadurch gekennzeichnet, dass** sie als Photovoltaikdachpfanne (1) zur Gewinnung elektrischer Energie aus Sonnenstrahlung ausgebildet ist und dass das Solarenergienutzungsmodul als Photovoltaikmodul ausgebildet ist.

3. Solarenergiedachpfanne nach Anspruch 1, **dadurch gekennzeichnet, dass** sie als Solarthermiedachpfanne zur Gewinnung thermischer Energie aus Sonnenstrahlung ausgebildet ist und dass das Solarenergienutzungsmodul als Solarthermiemodul ausgebildet ist.

4. Solarenergiedachpfanne nach Anspruch 1, **dadurch gekennzeichnet, dass** sie als kombinierte Dachpfanne zur Gewinnung elektrischer und thermischer Energie aus Sonnenstrahlung ausgebildet ist und dass das Solarenergienutzungsmodul sowohl als Photovoltaikmodul als auch als Solarthermiemodul ausgebildet ist.

5. Solarenergiedachpfanne nach einem Ansprüche 1 bis 4, **dadurch gekennzeichnet, dass** die untere Öffnung als eine Einströmöffnung (12) für aus der Umgebung (U) anströmende Umgebungsluft in den Hohlraum (10) und die obere Öffnung als eine Ausströmöffnung (11) für die Umgebungsluft aus dem Hohlraum (10) ausgebildet ist.

6. Solarenergiedachpfanne nach einem Ansprüche 1 bis 5, **dadurch gekennzeichnet, dass** die Unterseite (2) im Wesentlichen durch ein Bodenblech (3) gebildet ist, und dass das Bodenblech (3) im Bereich der unteren Öffnung wenigstens eine Blechlasche (37), vorzugsweise zwei Blechlaschen (37), aufweist.

7. Solarenergiedachpfanne nach Anspruch 6, **dadurch gekennzeichnet, dass** sich die Blechlasche (37) in einem Grundzustand der Solarenergiedachpfanne im Wesentlichen parallel zu einer Grundebene (E) des Bodenblechs (3) erstreckt, und dass die Blechlasche (37) in einem Montagezustand der Solarenergiedachpfanne auf einem Dach einen im Wesentlichen senkrecht zur Grundebene (E) verlaufenden Vertikalabschnitt (42) sowie einen an den Vertikalabschnitt (42) anschließenden, im Wesentlichen parallel zur Grundebene (E) verlaufenden Horizontalabschnitt (43) aufweist.

8. Solarenergiedachpfanne nach Anspruch 6 oder 7, **dadurch gekennzeichnet, dass** die Blechlasche (37) mehrere, in regelmäßigen Abständen zueinander angeordnete Bohrungen (38) aufweist.

9. Solarenergiesystem aufweisend wenigstens zwei miteinander verbundene Solarenergiedachpfannen nach einem der Ansprüche 1 bis 8, wobei die obere Öffnung der im Montagezustand unterhalb angeordneten Solarenergiedachpfanne wenigstens teilweise mit der unteren Öffnung der im Montagezustand oberhalb angeordneten Solarenergiedachpfanne in Übereinstimmung gebracht ist.

10. Solarenergiesystem nach Anspruch 9, **dadurch gekennzeichnet, dass** an die obere Öffnung der im Montagezustand zuoberst angeordneten Solarenergiedachpfanne anschließend ein Verbraucher, insbesondere in Form einer Wärmepumpe oder eines Wärmetauschers, vorgesehen ist, der die durch die erwärmte Umgebungsluft zur Verfügung gestellte Wärmeenergie nutzt.

11. Solarenergiesystem nach Anspruch 9 oder 10, **dadurch gekennzeichnet, dass** ein Potentialausgleichselement (41) vorgesehen ist, welches Potentialausgleichselement (41) sich zumindest teilweise wenigstens durch die beiden Unterseiten (2) der wenigstens zwei miteinander verbundenen Solarenergiedachpfannen erstreckt, wobei vorzugsweise das Potentialausgleichselement (41) derart angeordnet ist, dass das Potentialausgleichselement (41) das Bodenblech (3) der im Montagezustand unterhalb angeordneten Solarenergiedachpfanne mit der Blechlasche (37) der im Montagezustand oberhalb angeordneten Solarenergiedachpfanne miteinander verbindet.

12. Verfahren zur Gewinnung von Energie aus Sonnenstrahlung und gleichzeitiger Nutzung der Abwärme, wobei mittels einer nach einem der Ansprüche 1 bis 8 ausgebildeten Solarenergiedachpfanne mithilfe eines Solarenergienutzungsmoduls aus Sonnenstrahlung thermische und/oder elektrische Energie hergestellt wird und die dabei durch eine Erwärmung des Solarenergienutzungsmoduls entstehende Abwärme an vorbeiströmende Umgebungsluft abgegeben wird und die sich erwärmte Umgebungsluft einem Verbraucher, insbesondere in Form einer Wärmepumpe oder eines Wärmetauschers, zugeführt wird.

13. Verfahren nach Anspruch 12, **dadurch gekennzeichnet, dass** mehrere Solarenergiedachpfannen nach einem der Ansprüche 1 bis 8, vorzugsweise in einem Solarenergiesystem nach Anspruch 9 oder 10, vorgesehen sind und auf einer Dachkonstruktion montiert werden, dass Umgebungsluft durch die im Montagezustand zuunterst angeordnete Solarenergiedachpfanne angesaugt wird, dass die angesaugte Umgebungsluft über die Ausströmöffnung (11) und Einströmöffnung (12) jeweils benachbarter Solarenergiedachpfannen durch die Hohlräume (10) der benachbarten Solarenergiedachpfannen geführt wird, und dass die erwärmte Umgebungsluft von der im Montagezustand zuoberst angeordneten Solarenergiedachpfanne abgesaugt und einem Verbraucher zugeführt wird.

## Claims

1. A solar energy roof tile having a shape substantially corresponding to that of a conventional roof tile and connectable in a thermally and/or electrically conductive manner to a neighboring solar energy roof tile, comprising:
- a bottom side (2) for at least partial placement on a roof structure,
- a top side (8) opposite the bottom side (2) and at least partially formed by a solar energy utilization module,
- two opposite side walls (5, 6),
- a rear side (7) connecting the two side walls (5, 6), and
- a front side (4) opposite the rear side (7) and also connecting the two side walls (5, 6),
wherein the two side walls (5, 6), the rear side (7), and the front side (4) together connect the bottom side (2) and the top side (8), such that a cavity (10) is formed between the two side walls (5, 6), the rear side (7), the front side (4), the bottom side (2), and the top side (8),
wherein the bottom side (2) comprises a lower opening in a region of the front side (4) for providing access and the top side (8) comprises an upper opening in a region of the rear side (7) for providing access from an environment (U) into the cavity (10), **characterized in that** the top side (8) comprises a sliding cover configured to slide in a longitudinal direction (L) extending from the front side (4) to the rear side (7).

2. The solar energy roof tile according to claim 1, **characterized in that** it is formed as a photovoltaic roof tile (1) for obtaining electrical energy from solar radiation and the solar energy utilization module is formed as a photovoltaic module.

3. The solar energy roof tile according to claim 1, **characterized in that** it is formed as a solar thermal roof tile for obtaining thermal energy from solar radiation and the solar energy utilization module is formed as a solar thermal module.

4. The solar energy roof tile according to claim 1, **characterized in that** it is formed as a combined roof tile for obtaining electrical and thermal energy from solar radiation and the solar energy utilization module is formed as both a photovoltaic module and a solar thermal module.

5. Solar energy roof tile according to any one of claims 1 to 4, **characterized in that** the lower opening is formed as an inlet opening (12) for ambient air flowing from the environment (U) into the cavity (10) and the upper opening is formed as an outlet opening (11) for the ambient air from the cavity (10).

6. The solar energy roof tile according to any one of claims 1 to 5, **characterized in that** the bottom side (2) is substantially formed by a bottom sheet (3), and the bottom sheet (3) comprises at least one metal tab (37), preferably two metal tabs (37), in a region of the lower opening.

7. The solar energy roof tile according to claim 6, **characterized in that** the metal tab (37) extends substantially parallel to a base plane (E) of the bottom sheet (3) in an initial state of the solar energy roof tile, and the metal tab (37) comprises a vertical section (42) extending substantially perpendicular to the base plane (E) as well as a horizontal section (43) continuous with the vertical section (42) and extending substantially parallel to the base plane (E) in an assembled state of the solar energy roof tile on a roof.

8. The solar energy roof tile according to claim 6 or 7, **characterized in that** the metal tab (37) comprises a plurality of bores (38) arranged at regular intervals relative to one another.

9. A solar energy system comprising at least two connected solar energy roof tiles according to any one of claims 1 to 8, wherein the upper opening of the lower solar energy roof tile in the assembled state is at least partially aligned with the lower opening of the upper solar energy roof tile in the assembled state.

10. The solar energy system according to claim 9, **characterized in that** a consumer, in particular in form of a heat pump or a heat exchanger, is provided adjacent to the upper opening of the topmost solar energy roof tile in the assembled state, the consumer utilizing the thermal energy made available by the warmed ambient air.

11. The solar energy system according to claim 9 or 10, **characterized in that** an equipotential bonding element (41) is provided and extends at least partially through both bottom sides (2) of the at least two connected solar energy roof tiles, preferably, the equipotential bonding element (41) is arranged such that the equipotential bonding element (41) connects the bottom sheet (3) of the lower solar energy roof tile in the assembled state to the metal tab (37) of the upper solar energy roof tile in the assembled state.

12. A method for obtaining energy from solar radiation and simultaneous utilization of waste heat, wherein thermal and/or electrical energy is produced from solar radiation by means of a solar energy utilization module of a solar energy roof tile formed according to any one of claims 1 to 8, and the waste heat generated by heating of the solar energy utilization module is released to ambient air flowing past, and the warmed ambient air is supplied to a consumer, in particular in the form of a heat pump or a heat exchanger.

13. The method according to claim 12, **characterized in that** a plurality of solar energy roof tiles according to any one of claims 1 to 8 are provided, preferably in a solar energy system according to claim 9 or 10, and are mounted on a roof structure, ambient air is sucked in through the bottommost solar energy roof tile in the assembled state, the sucked-in ambient air is guided through the cavities (10) of neighboring solar energy roof tiles via the outlet opening (11) and inlet opening (12) of respective neighboring solar energy roof tiles, and the warmed ambient air is sucked out from the topmost solar energy roof tile in the assembled state and supplied to a consumer.

## Revendications

1. Tuile solaire, dont la forme correspond essentiellement à la forme d'une tuile classique et qui peut être reliée de manière thermiquement et/ou électriquement conductrice à une tuile solaire voisine, comprenant :
- une face inférieure (2) pour un appui au moins par zones sur une structure de toit,
- une face supérieure (8) opposée à la face inférieure (2), qui est formée au moins par zones par un module d'utilisation d'énergie solaire,
- deux parois latérales (5, 6) opposées,
- une face arrière (7) reliant les deux parois latérales (5, 6), et
- une face avant (4) opposée à la face arrière (7) et reliant également les deux parois latérales (5, 6),
les deux parois latérales (5, 6), la face arrière (7) ainsi que la face avant (4) reliant ensemble la face inférieure (2) et la face supérieure (8), de telle sorte qu'une cavité (10) soit formée entre les deux parois latérales (5, 6), la face arrière (7), la face avant (4), la face inférieure (2) et la face supérieure (8),
la face inférieure (2) comprenant dans la zone de la face avant (4) une ouverture inférieure pour la fourniture d'un accès et la face supérieure (8) comprenant dans la zone de la face arrière (7) une ouverture supérieure pour la fourniture d'un accès de l'environnement (U) dans la cavité (10), **caractérisée en ce que** la face supérieure (8) comprend une couverture formée de manière déplaçable dans une direction longitudinale (L) s'étendant de la face avant (4) à la face arrière (7).

2. Tuile solaire selon la revendication 1, **caractérisée en ce qu'**elle est formée comme une tuile photovoltaïque (1) pour l'obtention d'énergie électrique à partir du rayonnement solaire, et que le module d'utilisation d'énergie solaire est formé comme un module photovoltaïque.

3. Tuile solaire selon la revendication 1, **caractérisée en ce qu'**elle est formée comme une tuile de thermie solaire pour l'obtention d'énergie thermique à partir du rayonnement solaire, et que le module d'utilisation d'énergie solaire est formé comme un module de thermie solaire.

4. Tuile solaire selon la revendication 1, **caractérisée en ce qu'**elle est formée comme une tuile combinée pour l'obtention d'énergie électrique et thermique à partir du rayonnement solaire, et que le module d'utilisation d'énergie solaire est formé tant comme un module photovoltaïque que comme un module de thermie solaire.

5. Tuile solaire selon l'une quelconque des revendications 1 à 4, **caractérisée en ce que** l'ouverture inférieure est formée comme une ouverture d'entrée (12) pour de l'air ambiant venant de l'environnement (U) dans la cavité (10) et l'ouverture supérieure est formée comme une ouverture de sortie (11) pour l'air ambiant hors de la cavité (10).

6. Tuile solaire selon l'une quelconque des revendications 1 à 5, **caractérisée en ce que** la face inférieure (2) est formée essentiellement par une tôle de fond (3), et que la tôle de fond (3) comprend dans la zone de l'ouverture inférieure au moins une languette en tôle (37), de préférence deux languettes en tôle (37).

7. Tuile solaire selon la revendication 6, **caractérisée en ce que** la languette en tôle (37) s'étend, dans un état de base de la tuile solaire, essentiellement parallèle à un plan de base (E) de la tôle de fond (3) et que la languette en tôle (37) comprend, dans un état monté de la tuile solaire sur un toit, une partie verticale (42) s'étendant essentiellement perpendiculaire au plan de base (E) ainsi qu'une partie horizontale (43) se raccordant à la partie verticale (42) et s'étendant essentiellement parallèle au plan de base (E).

8. Tuile solaire selon la revendication 6 ou 7, **caractérisée en ce que** la languette en tôle (37) comprend plusieurs alésages (38) disposés à des distances régulières les uns des autres.

9. Système d'énergie solaire comprenant au moins deux tuiles solaires selon l'une quelconque des revendications 1 à 8 reliées entre elles, l'ouverture supérieure de la tuile solaire disposée en bas à l'état monté étant au moins partiellement mise en concordance avec l'ouverture inférieure de la tuile solaire disposée en haut à l'état monté.

10. Système d'énergie solaire selon la revendication 9, **caractérisé en ce qu'**un consommateur, en particulier sous la forme d'une pompe à chaleur ou d'un échangeur de chaleur, qui utilise l'énergie thermique mise à disposition par l'air ambiant chauffé, est prévu au niveau de l'ouverture supérieure de la tuile solaire disposée le plus en haut à l'état monté.

11. Système d'énergie solaire selon la revendication 9 ou 10, **caractérisé en ce qu'**un élément d'équilibrage de potentiel (41) est prévu, lequel élément d'équilibrage de potentiel (41) s'étend au moins partiellement au moins à travers les deux faces inférieures (2) des au moins deux tuiles solaires reliées entre elles, l'élément d'équilibrage de potentiel (41) étant de préférence disposé de telle façon que l'élément d'équilibrage de potentiel (41) relie la tôle de fond (3) de la tuile solaire disposée en bas à l'état monté à la languette en tôle (37) de la tuile solaire disposée en haut à l'état monté.

12. Procédé d'obtention d'energie à partir du rayonnement solaire et d'utilisation simultanée de la chaleur perdue, dans lequel, au moyen d'une tuile solaire formée selon l'une quelconque des revendications 1 à 8 aidée par un module d'utilisation d'énergie solaire, de l'énergie thermique et/ou électrique est produite à partir du rayonnement solaire et la chaleur perdue générée ce faisant par un réchauffement du module d'utilisation d'énergie solaire est transmise à l'air ambiant et l'air ambiant réchauffé est acheminé à un consommateur, notamment sous la forme d'une pompe à chaleur ou d'un échangeur de chaleur.

13. Procédé selon la revendication 12, **caractérisé en ce que** plusieurs tuiles solaires selon l'une quelconque des revendications 1 à 8 sont prévues, de préférence dans un système d'énergie solaire selon la revendication 9 ou 10, et montées sur une structure de toit, que l'air ambiant est aspiré par la tuile solaire disposée le plus en bas à l'état monté, que l'air ambiant aspiré est guidé à travers les cavités (10) par l'ouverture de sortie (11) et l'ouverture d'entrée (12) de tuiles solaires respectivement voisines, et que l'air ambiant chauffé est évacué de la tuile solaire disposée le plus en haut à l'état monté et acheminé à un consommateur.
